# EUROPEAN PATENT APPLICATION

(11) **EP 4 060 077 A2**
(43) Date of publication of application: **21.09.2022**
(21) Application number: 22156630.0
(22) Date of filing: 14.02.2022
(51) Int. Cl.: C23C 16/455

(54) **SUBSTRATE PROCESSING APPARATUS, METHOD OF MANUFACTURING SEMICONDUCTOR DEVICE AND PROGRAM**

(30) Priority: 16.03.2021 JP 2021042385
(71) Applicant: Kokusai Electric Corp., Tokyo 1010045 (JP)
(72) Inventor: SATO, Taketoshi, Toyama-shi, 939-2393 (JP); ITATANI, Hideharu, Toyama-shi, 939-2393 (JP); SAMBU, Makoto, Toyama-shi, 939-2393 (JP)
(74) Representative: Verscht, Thomas Kurt Albert

(57) **Abstract**

Described herein is a substrate processing technique of preventing particle generation while lowering an inner pressure of a nozzle and improving a film thickness uniformity. According to one aspect thereof, a substrate processing apparatus includes a boat for supporting substrates; an inner tube surrounding the boat and provided with an exhaust hole through which a gas is exhausted along a direction orthogonal to an arrangement direction of the substrates; a mixing structure for generating a mixed gas for processing the substrates; and a nozzle installed apart from an inner lateral surface of the inner tube and through which the mixed gas supplied from the mixing structure is discharged into the inner tube via discharge holes arranged at the nozzle along the arrangement direction of the substrates. A discharge direction of each of the discharge holes is not toward the boat but toward the inner lateral surface of the inner tube.

## Description

### [Technical Field]

The present disclosure relates to a substrate processing apparatus, a method of manufacturing a semiconductor device and a program.

### [Related Art]

Conventionally, a process (also referred to as a "film-forming process") of forming a film of a desired quality on a plurality of substrates (wafers) including a substrate, which are arranged along a predetermined arrangement direction and surrounded by an inner tube, may be performed by supplying a gas for a substrate processing into the inner tube. According to Patent Document 1 and Patent Document 2, as a substrate processing apparatus, a vertical type apparatus in which the plurality of substrates are arranged along a vertical direction inside the inner tube (which is a cylindrical heating structure or a reaction tube) and provided with a nozzle extending along the vertical direction in the vicinity of the plurality of substrates may be used. According to Patent Document 1 and Patent Document 2 described above, a plurality of discharge holes (gas supply holes) that are open in the inner tube are provided at the nozzle along a vertical direction so as to supply the gas to the plurality of substrates.

### [Related Art Document]

### [Patent document]

Patent Document 1: Japanese Patent Laid-Open No. H06-349761
Patent Document 1: Japanese Patent Laid-Open No. 2014-175494

### [Disclosure]

### [Technical Problem]

When the plurality of discharge holes are arranged in the single nozzle, an inner pressure of the nozzle may decrease from an upstream end to a downstream end of the nozzle. Therefore, a pressure difference between an inside and an outside of the nozzle that is caused by each of the plurality of discharge holes decreases along a downward direction. That is, a pressure difference caused by a discharge hole at a downstream location of the nozzle is smaller than a pressure difference caused by a discharge hole at an upstream location of the nozzle. Therefore, a non-uniformity of a supply amount of the gas may increase at a region between a substrate among the plurality of substrates located in an upstream portion of the nozzle and a substrate among the plurality of substrates located in a downstream portion of the nozzle.

As a method of decreasing the non-uniformity of the supply amount of the gas, it is possible to consider, for example, a method of increasing the inner pressure of the nozzle and decreasing an influence of the pressure difference between the inside and the outside of the nozzle caused by the discharge hole located in the downstream portion. However, as the inner pressure of the nozzle increases, the gas tends to subject to thermal decomposition more easily in the nozzle.

Further, when a mixed gas in which a plurality of gases are mixed is supplied at once using the same nozzle, an increase in the inner pressure of the nozzle may cause an abnormal reaction between the plurality of gases to occur more easily in the nozzle. As a result, the generation of particles in the inner tube may increase. In addition, a new film precursor, which is an undesirable precursor for the film-forming process, may be generated by the abnormal reaction between the plurality of gases. Therefore, a thickness uniformity of the film on a surface of the substrate and a thickness uniformity of the films between the plurality of substrates may deteriorate.

According to Patent Document 1, there is disclosed a method of decreasing the non-uniformity of the supply amount of the gas by reducing an interval between adjacent discharge holes among the plurality of discharge holes from the upstream end to the downstream end of the nozzle (that is, by setting the interval between adjacent discharge holes in the upstream portion of the nozzle greater than the interval, i.e., pitch between adjacent discharge holes in the downstream portion of the nozzle) to thereby discharge a reactive gas with a constant flow rate per unit length of the nozzle.

However, according to Patent Document 1, the gas supplied through the single nozzle is the reactive gas alone, and a case where the mixed gas in which the plurality of gases are mixed is supplied through the same nozzle is not considered in Patent Document 1. Therefore, according to Patent Document 1, it may not be possible to sufficiently address the problems described above such as the generation of the particles by the abnormal reaction between the plurality of gases, the deterioration of the thickness uniformity of the film on the surface of the substrate and the deterioration of the thickness uniformity of the films between the plurality of substrates.

Further, as in Patent Document 1, the plurality of gases may not be sufficiently dispersed and mixed even though the inner pressure of the nozzle is lowered to a certain extent by reducing the interval between the adjacent discharge holes. As a result, the mixed gas of a desired concentration may not be homogenized and uniformly supplied to each substrate. Therefore, when the mixed gas in which the plurality of gases are mixed is supplied through the nozzle, it may be difficult to decrease the inner pressure of the nozzle by simply applying the technique of Patent Document 1.

Further, according to Patent Document 2, there is disclosed a configuration in which a discharge direction of the discharge hole is toward a position where the substrate is not placed in order to prevent the particles and metal contaminants generated from a process gas from adhering to the surface of the substrate. Thereby, the process gas discharged through the discharge hole flows to bypass the substrate. According to Patent Document 2 described above, the gas supplied through the single nozzle is the process gas alone. Therefore, similar to Patent Document 1 described above, it may not be possible to sufficiently address the problems described above such as the generation of the particles by the abnormal reaction between the plurality of gases, the deterioration of the thickness uniformity of the film on the surface of the substrate and the deterioration of the thickness uniformity of the films between the plurality of substrates.

In addition, according to the Patent Document 2 described above, the nozzle is arranged in contact with an inner lateral surface of the inner tube. Therefore, according to the configuration in which the discharge direction of the discharge hole is toward the position where the substrate is not placed, the discharge hole may contact the inner lateral surface of the inner tube. Thus, a gas passage between the discharge hole and the inner lateral surface of the inner tube may be narrowed, and as a result, the inner pressure of the nozzle may increase while the gas is being discharged. Thereby, a thermal decomposition of the gas and the abnormal reaction between the plurality of gases may occur in the nozzle.

In order to address the problems described above, according to the present disclosure, there is provided a technique capable of preventing particles from being generated while lowering an inner pressure of a nozzle and capable of improving a thickness uniformity of a film on a surface of a substrate and a thickness uniformity of films between a plurality of substrates when a mixed gas in which a plurality of gases are mixed is supplied to the plurality of substrates in an inner tube as a process gas by using the same nozzle.

### [Technical Solution]

According to one or more embodiments of the present disclosure, there is provided a technique related to a substrate processing apparatus that including: a boat configured to arrange and support a plurality of substrates along a predetermined arrangement direction; an inner tube installed so as to surround the boat and provided with an exhaust hole through which a gas is exhausted along a direction orthogonal to the arrangement direction of the plurality of substrates; a mixing structure configured to generate a mixed gas by mixing a plurality of gases for processing the plurality of substrates , wherein the plurality of gases react with each other at an inner temperature of the inner tube; and a nozzle installed apart from an inner lateral surface of the inner tube and through which the mixed gas supplied from the mixing structure is discharged into the inner tube via a plurality of discharge holes arranged at the nozzle along the arrangement direction of the plurality of substrates, wherein a discharge direction of each of the plurality of discharge holes is not toward the boat but toward the inner lateral surface of the inner tube.

### [Advantageous Effects]

According to some embodiments of the technique of the present disclosure, it is possible to prevent the particles from being generated while lowering the inner pressure of the nozzle and also possible to improve the thickness uniformity of the film on the surface of the substrate and the thickness uniformity of the films between the plurality of substrates when the mixed gas in which a plurality of gases are mixed is supplied to the plurality of substrates in the inner tube as the process gas by using the same nozzle.

### [Brief Description of Drawings]

FIG. 1 is a diagram schematically illustrating a vertical cross-section of a vertical type process furnace of a substrate processing apparatus according to one or more embodiments of the present disclosure.
FIG. 2 is a diagram schematically illustrating a horizontal cross-section, taken along the line 2 - 2 shown in FIG. 1, of the vertical type process furnace of the substrate processing apparatus according to the embodiments of the present disclosure.
FIG. 3 is a block diagram schematically illustrating a configuration of a controller and related components of the substrate processing apparatus according to the embodiments of the present disclosure.
FIG. 4 is a flowchart schematically illustrating a method of manufacturing a semiconductor device according to the embodiments of the present disclosure.
FIG. 5 is a graph schematically illustrating a relationship between a separation distance from a discharge hole of the most upstream location of a nozzle and an inner pressure of the nozzle measured at each position of a plurality of discharge holes.
FIG. 6 is a graph schematically illustrating a relationship between the separation distance from the discharge hole of the most upstream location of the nozzle and a gas flow rate ratio at each position of the plurality of discharge holes.
FIG. 7 is a diagram schematically illustrating a horizontal cross-section, taken along the line 2 - 2 shown in FIG. 1, of a vertical type process furnace of a substrate processing apparatus according to a first modified example of the present disclosure.
FIG. 8 is a diagram schematically illustrating a horizontal cross-section, taken along the line 2 - 2 shown in FIG. 1, of a vertical type process furnace of a substrate processing apparatus according to a second modified example of the present disclosure.
FIG. 9 is a diagram schematically illustrating a horizontal cross-section, taken along the line 2 - 2 shown in FIG. 1, of a vertical type process furnace of a substrate processing apparatus according to a third modified example of the present disclosure.
FIG. 10 is a diagram schematically illustrating a buffer structure of a substrate processing apparatus according to a fourth modified example of the present disclosure when viewed along a direction from a center of a wafer toward an outer periphery of the wafer.
FIG. 11 is a diagram schematically illustrating a horizontal cross-section, taken along the line 11 - 11 shown in FIG. 10, of the buffer structure of the substrate processing apparatus according to the fourth modified example of the present disclosure.

### [Detailed Description]

### <Embodiments>

Hereinafter, one or more embodiments (also simply referred to as "embodiments") according to the technique of the present disclosure will be described. In the following descriptions of the embodiments, the same or similar reference numerals represent the same or similar components in the drawings, and redundant descriptions related thereto will be omitted. However, the drawings used in the following descriptions are all schematic. For example, a relationship between a thickness and plane dimensions of each component and a ratio of a thickness of each apparatus and each component shown in the drawing may be different from the actual ones. Therefore, the specific thickness and dimensions are preferably determined in consideration of the following descriptions. Further, for example, even between the drawings, a relationship between the dimensions of each component and the ratio of each component may not always match. Further, an upper direction of each drawing may be described as "above" or "upper portion", and a lower direction of each drawing may be described as "below" or "lower portion". Further, the term "pressure" described in the embodiments refers to an "atmospheric pressure" unless otherwise specified.

### <Configuration of Substrate Processing Apparatus>

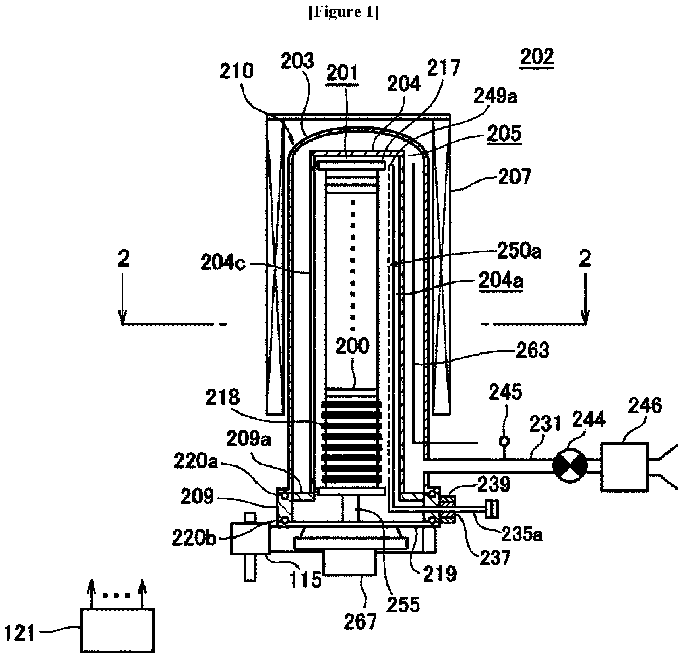

A substrate processing apparatus according to the present embodiments will be described with reference to FIGS. 1 through 3. The substrate processing apparatus according to the present embodiments includes a process furnace 202. The process furnace 202 includes a heater 207 serving as a heating apparatus (which is a heating structure or a temperature regulator). The heater 207 is of a cylindrical shape, and is vertically installed while being supported by a support plate (not shown). The heater 207 also functions as an activator (also referred to as an "exciter") capable of activating (exciting) a gas such as a source gas and a reactive gas described later by heat.

A reaction tube 210 is provided in an inner side of the heater 207 to be aligned in a manner concentric with the heater 207. For example, the reaction tube 210 is embodied by a double tube configuration including an inner tube 204 serving as an inner reaction tube and an outer tube 203 serving as an outer reaction tube provided to surround the inner tube 204 and to be aligned in a manner concentric with the inner tube 204. For example, each of the inner tube 204 and the outer tube 203 is made of a heat resistant material such as quartz (SiO₂) and silicon carbide (SiC). For example, each of the inner tube 204 and the outer tube 203 is of a cylindrical shape with a closed upper end and an open lower end.

The inner tube 204 is installed so as to surround a boat 217 described later. In addition, a side wall of the inner tube 204 extends vertically along the vertical direction. Further, according to the present embodiments, a ceiling structure provided with an end face configured to close the upper end of the inner tube 204 is provided on an upper portion of the inner tube 204.

A process chamber 201 in which a plurality of wafers including a wafer 200 serving as a substrate are processed is provided in a hollow cylindrical portion of the inner tube 204. Hereinafter, the plurality of wafers including the wafer 200 may also simply be referred to as wafers 200. The process chamber 201 is configured such that the wafers 200 can be accommodated in the process chamber 201 while being arranged in the process chamber 201 along a direction perpendicular to a surface of the wafer 200 from an end (that is, a lower end) toward the other end (that is, an upper end) of the process chamber 201. In the present embodiments, a region in the process chamber 201 in which the wafers 200 are arranged in the process chamber 201 may also be referred to as a "substrate arrangement region" or a "wafer arrangement region". In addition, a direction in which the wafers 200 are arranged in the process chamber 201 may also be referred to as a "substrate arrangement direction" or a "wafer arrangement direction".

Each of the inner tube 204 and the outer tube 203 is supported by a manifold 209 from thereunder. The manifold 209 is made of a metal material such as stainless steel (SUS). The manifold 209 is of a cylindrical shape with open upper and lower ends. A flange 209a of an annular shape, which is made of a metal material such as the SUS and extends inward along a radial direction of the manifold 209, is provided at an upper end portion of an inner lateral surface of the manifold 209. The lower end of the inner tube 204 is in contact with an upper surface of the flange 209a. The lower end of the outer tube 203 is in contact with the upper end of the manifold 209. An O-ring 220a serving as a seal is provided between the manifold 209 and the outer tube 203. A lower end opening of the manifold 209 is configured as a furnace opening of the process furnace 202, and is airtightly (hermetically) sealed by a seal cap 219 of a disk shape serving as a lid when the boat 217 is elevated by a boat elevator 115 described later. An O-ring 220b serving as a seal is provided between the manifold 209 and the seal cap 219.

The ceiling structure of the inner tube 204 is of a flat shape, and a ceiling structure of the outer tube 203 is of a dome shape. When the ceiling structure of the inner tube 204 is of a dome shape, the gas supplied into the process chamber 201 may not flow between the wafers 200 and may easily flow into an inner space of a dome in the ceiling structure of the inner tube 204. By configuring the ceiling structure of the inner tube 204 into a flat shape, the gas supplied into the process chamber 201 can efficiently flow between the wafers 200. By reducing a clearance (space) between the ceiling structure of the inner tube 204 and a top plate of the boat 217 described later, for example, by setting the clearance substantially equal to an arrangement interval (pitch) between adjacent ones among the wafers 200, it is possible to efficiently supply the gas between the wafers 200.

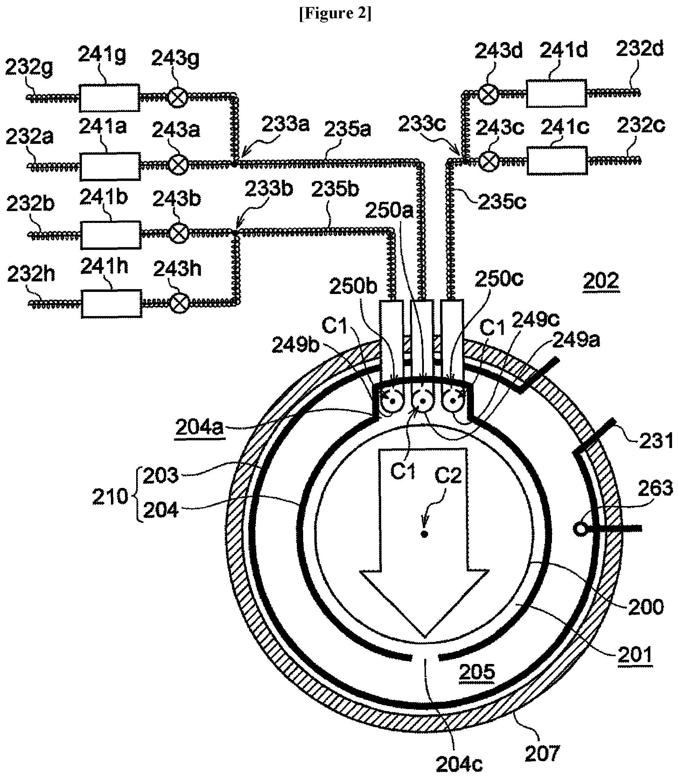

As shown in FIG. 2, a buffer structure 204a in which nozzles 249a, 249b and 249c are accommodated is provided on the side wall of the inner tube 204. The buffer structure 204a is of a channel shape protruding outward along a radial direction of the inner tube 204 from the side wall of the inner tube 204 and extending (or stretching) along the vertical direction. An inner lateral surface (wall) of the buffer structure 204a constitutes a part of an inner lateral surface (wall) of the process chamber 201. The nozzles 249b and 249c accommodated in the buffer structure 204a are arranged on both sides of the nozzle 249a, respectively, such that the nozzle 249a is interposed between the nozzle 249b and the nozzle 249c along the inner lateral surface of the buffer structure 204a (that is, along an outer peripheral portion of each of the wafers 200).

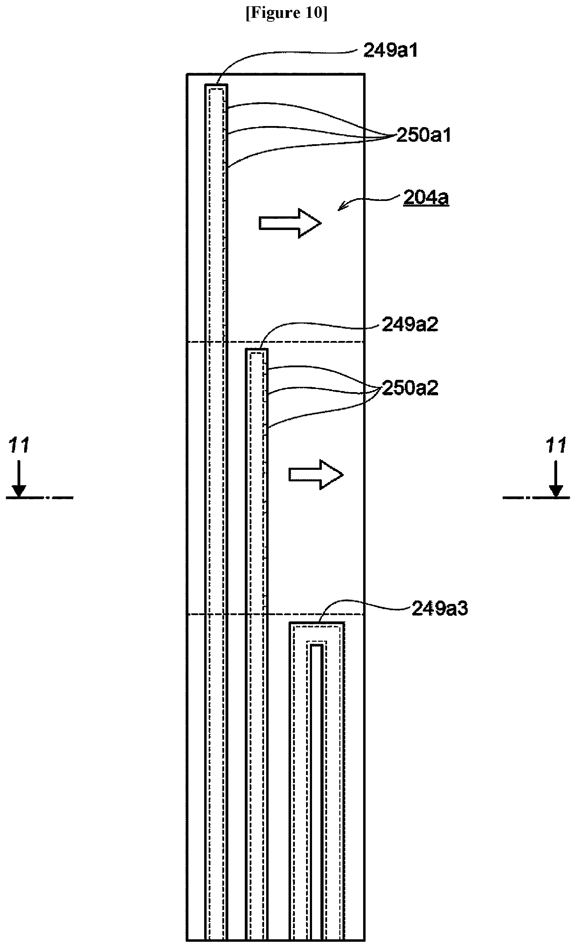

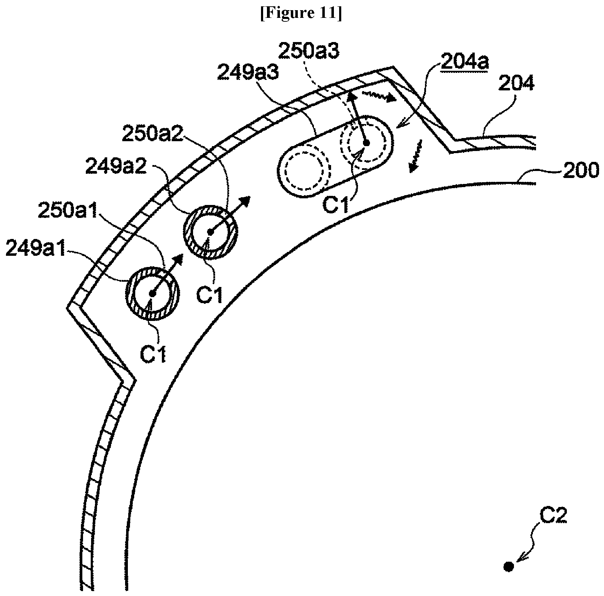

The nozzles 249a, 249b and 249c are installed so as to extend upward from a lower portion toward an upper portion of the buffer structure 204a, that is, along the wafer arrangement direction. That is, the nozzles 249a, 249b and 249c are installed at a side portion of the wafer arrangement region, that is, in a region that horizontally surrounds the wafer arrangement region along the wafer arrangement direction. As shown in FIG. 2, a plurality of discharge holes including a discharge hole 250a serving as a first gas supply hole, a plurality of discharge holes including a discharge hole 250b serving as a second gas supply hole and a plurality of discharge holes including a discharge hole 250c serving as a third gas supply hole are provided at side surfaces of the nozzles 249a, 249b and 249c, respectively. Hereinafter, the plurality of discharge holes including the discharge hole 250a may also be simply referred to as discharge holes 250a. The same also applies to the plurality of discharge holes including the discharge hole 250b and the plurality of discharge holes including the discharge hole 250c. The same also applies to a plurality of discharge holes including a discharge hole 250a1, a plurality of discharge holes including a discharge hole 250a2 and a plurality of discharge holes including a discharge hole 250a3, which are described later with reference to FIGS. 10 and 11. For example, each of the nozzles 249a, 249b and 249c is made of a heat resistant material such as quartz and silicon carbide (SiC).

The wafer arrangement region described above may be considered as a plurality of zones divided along the vertical direction in FIG. 1. According to the present embodiments, among the plurality of zones, a zone disposed on one end (an upper end) in the wafer arrangement direction of the wafer arrangement region may also be referred to as a "first zone" or a "top zone". Further, among the plurality of zones, a zone disposed on a center portion in the wafer arrangement direction of the wafer arrangement region may also be referred to as a "second zone" or a "center zone". In addition, among the plurality of zones, a zone disposed on the other end (a lower end) in the wafer arrangement direction of the wafer arrangement region may also be referred to as a "third zone" or a "bottom zone".

The discharge holes 250a of the nozzle 249a, the discharge holes 250b of the nozzle 249b and the discharge holes 250c of the nozzle 249c are provided from upper portions to lower portions of the nozzles 249a, 249b and 249c, respectively, so as to correspond to the entire area of the wafer arrangement region along the wafer arrangement direction. Each of the nozzles 249a, 249b and 249c is configured such that the gas can be supplied to the entirety of the first zone, the second zone and the third zone through the nozzles 249a, 249b and 249c, respectively

As shown in FIG. 2, gas supply pipes 232a, 232b and 232c are connected to the nozzles 249a, 249b and 249c, respectively. Mass flow controllers (MFCs) 241a, 241b and 241c serving as flow rate controllers (flow rate control structures) and valves 243a, 243b and 243c serving as opening/closing valves are sequentially installed at the gas supply pipes 232a, 232b and 232c in this order from upstream ends to downstream ends of the gas supply pipes 232a, 232b and 232c, respectively, in a gas flow direction. A gas supply pipe 232g is connected to the gas supply pipe 232a at a downstream end of the valve 243a of the gas supply pipe 232a. An MFC 241g and a valve 243g are sequentially installed at the gas supply pipe 232g in this order from an upstream end to a downstream end of the gas supply pipe 232g in the gas flow direction. A gas supply pipe 232h is connected to the gas supply pipe 232b located downstream of the valve 243b of the gas supply pipe 232b. An MFC 241h and a valve 243h are sequentially installed at the gas supply pipe 232h in this order from an upstream end to a downstream end of the gas supply pipe 232h in the gas flow direction. A gas supply pipe 232d is connected to the gas supply pipe 232c located downstream of the valve 243c of the gas supply pipe 232c. An MFC 241d and a valve 243d are sequentially installed at the gas supply pipe 232d in this order from an upstream end to a downstream end of the gas supply pipe 232d in the gas flow direction.

The gas supply pipes 232a, 232b and 232c correspond to a "first supply pipe" of the technique of the present disclosure. The first supply pipe is connected to a supply source (not shown) of a first gas serving as one of a plurality of gases of the technique of the present disclosure. The gas supply pipes 232g, 232h and 232d correspond to a "second supply pipe" of the technique of the present disclosure. The second supply pipe is connected to a supply source (not shown) of a second gas serving as another of the plurality of gases of the technique of the present disclosure.

The plurality of gases for processing the wafers 200 react with each other at an inner temperature of the inner tube 204. Confluent portions 233a, 233b and 233c, where the first supply pipe and the second supply pipe join, correspond to a "mixing structure" of the technique of the present disclosure. The confluent portions 233a, 233b and 233c are configured such that the plurality of gases are mixed in advance in the confluent portions 233a, 233b and 233c to generate a mixed gas before the plurality of gases are supplied into the inner tube 204.

Gas supply pipes 235a, 235b and 235c corresponding to a "third supply pipe" of the technique of the present disclosure are provided between the confluent portion 233a and the nozzle 249a, between the confluent portion 233b and the nozzle 249b, and between the confluent portion 233c and the nozzle 249c, respectively. The third supply pipe is configured such that the confluent portions 233a, 233b and 233c fluidically communicate with the nozzles 249a, 249b and 249c, respectively, through the third supply pipe.

The mixed gas flows through the third supply pipe and is supplied to the nozzles 249a, 249b 249c. A gas supplier (which is a gas supply structure or a gas supply system) provided in the substrate processing apparatus is constituted by the first supply pipe, the second supply pipe, the mixing structure and the third supply pipe. In addition, a tape heater serving as an example of a piping heater is wound around each of the first supply pipe, the second supply pipe and the third supply pipe. The tape heater is configured to heat the gas flowing in the first supply pipe, the second supply pipe and the third supply pipe.

According to the present embodiments, a flow path area of the third supply pipe is equal to or greater than a total flow path area of the first supply pipe and the second supply pipe. For example, when a nominal diameter (in unit of inch) of each of the first supply pipe and the second supply pipe is 1/4, a nominal diameter of the third supply pipe may be set to 1/2. Alternatively, according to the present embodiments, the flow path area of the third supply pipe may not be equal to or greater than the total flow path area of the first supply pipe and the second supply pipe. In addition, a length of the third supply pipe may be set to be long enough for the first gas and the second gas to be uniformly mixed when the mixed gas discharged from the nozzles 249a, 249b and 249c collides with the inner lateral surface and then is supplied to the wafers 200.

A port 237 through which the first gas and the second gas merged with each other is introduced into the process furnace 202 is provided outside of the gas supply pipes 235a, 235b and 235c opposite to the confluent portions 233a, 233b and 233c, respectively (see FIG. 1). Further, at the port 237, a port heater 239 configured to heat the port 237 is provided on an outside of the port 237.

For example, the first gas serving as the source gas contains silicon (Si) serving as a main element constituting a film to be formed. The source gas is supplied into the process chamber 201 through the MFC 241a, the valve 243a and the nozzle 249a. For example, the term "source gas" may refer to a source in a gaseous state such as a gas obtained by vaporizing a source material in a liquid state under the normal temperature and the normal pressure and a source material in a gaseous state under the normal temperature and the normal pressure. A silane-based gas may be used as the source gas. For example, a gas containing silicon (Si) and a halogen element, that is, a halosilane-based gas may be used as the silane-based gas. The halosilane-based gas refers to a silane-based gas containing a halogen group. The halogen group includes the halogen element such as chlorine (Cl), fluorine (F), bromine (Br) and iodine (I). The halosilane-based gas acts as a silicon source.

For example, a chlorosilane gas such as monochlorosilane (SiH₃Cl, abbreviated as MCS) gas, dichlorosilane (SiH₂Cl₂, abbreviated as DCS) gas, trichlorosilane (SiHCl₃, abbreviated as TCS) gas, tetrachlorosilane (SiCl₄, abbreviated as STC) gas, hexachlorodisilane gas (Si₂Cl₆, abbreviated as HCDS) gas and octachlorotrisilane (Si₃Cl₈, abbreviated as OCTS) gas may be used as the source gas. One or more of the gases described above may be used as the source gas. For example, instead of the chlorosilane gas, a fluorosilane gas such as tetrafluorosilane (SiF₄) gas and difluorosilane (SiH₂F₂) gas, a bromosilane gas such as tetrabromosilane (SiBr₄) gas and dibromosilane (SiH₂Br₂) gas, or an iodine silane gas such as tetraiodide silane (SiI₄) gas and diiodosilane (SiH₂I₂) gas may be used as the source gas. One or more of the gases described above may be used as the source gas. For example, instead of the gases described above, a gas containing silicon and an amino group, that is, an aminosilane gas may be used as the source gas. The amino group refers to a monovalent functional group obtained by removing hydrogen (H) from ammonia, a primary amine or a secondary amine, and may be expressed as "-NH2", "-NHR" or "-NR2". In addition, "R" represents an alkyl group, and two "R"s of "-NR2" may be the same or different. For example, instead of the aminosilane gas, a gas containing silicon and an alkyl group, that is, an alkylsilane gas may be used as the source gas.

For example, the second gas serving as the reactive gas (reactant) contains a nitrogen (N)-containing gas or an oxygen (O)-containing gas. The reactive gas is supplied into the process chamber 201 through the MFC 241g, the valve 243g and the nozzle 249g. The nitrogen-containing gas acts as a nitriding agent (nitriding gas), that is, a nitrogen source. A gas containing nitrogen (N) and hydrogen (H), which is the nitriding gas (nitriding agent), may be used as the reactive gas. The gas containing nitrogen and hydrogen may serve as a hydrogen-containing gas as well as the nitrogen-containing gas. It is preferable that the gas containing nitrogen and hydrogen contains a nitrogen-hydrogen (N-H) bond. For example, a hydrogen nitride-based gas such as ammonia (NH₃) gas, diazene (N₂H₂) gas, hydrazine (N₂H₄) gas and N₃H₈ gas may be used as the reactive gas. One or more of the gases described above may be used as the reactive gas. For example, instead of the gases described above, a gas containing nitrogen, carbon (C) and hydrogen may be used as the reactive gas. For example, an amine-based gas or an organic hydrazine-based gas may be used as the gas containing nitrogen, carbon and hydrogen. The gas containing nitrogen, carbon and hydrogen may serve as a carbon-containing gas, the hydrogen-containing gas or a gas containing nitrogen and carbon as well as the nitrogen-containing gas.

For example, an ethylamine-based gas such as monoethyl amine (C₂H₅NH₂, abbreviated as MEA) gas, diethyl amine ((C₂H₅)₂NH, abbreviated as DEA) gas and triethyl amine ((C₂H₅)₃N, abbreviated as TEA) gas, a methylamine-based gas such as monomethyl amine (CH₃NH₂, abbreviated as MMA) gas, dimethyl amine ((CH₃)₂NH, abbreviated as DMA) gas and trimethyl amine ((CH₃)₃N, abbreviated as TMA) gas, or an organic hydrazine-based gas such as monomethyl hydrazine ((CH₃)HN₂H₂, abbreviated as MMH) gas, dimethylhydrazine ((CH₃)₂N₂H₂, abbreviated as DMH) gas and trimethyl hydrazine ((CH₃)₂N₂(CH₃)H, abbreviated as TMH) gas may be used as the reactive gas. One or more of the gases described above may be used as the reactive gas.

The oxygen-containing gas acts as an oxidizing agent (oxidizing gas), that is, an oxygen source. For example, a gas such as oxygen (O₂) gas, ozone (O₃) gas, plasma-excited O₂ gas (O₂^{∗}), a mixed gas of the O₂ gas and hydrogen (H₂) gas, water vapor (H₂O gas), hydrogen peroxide (H₂O₂) gas, nitrous oxide (N₂O) gas, nitrogen monoxide (NO) gas, nitrogen dioxide (NO₂) gas, carbon monoxide (CO) gas and carbon dioxide (CO₂) gas may be used as the oxygen-containing gas (that is, the reactive gas.).

In addition, an inert gas (or a carrier gas) may be supplied into the process chamber 201 through the gas supply pipes 232g, 232h and 232d provided with the MFC 241g, 241h and 241d and the valves 243g, 243h and 243d, respectively, the gas supply pipes 235a, 235b and 235c and the nozzles 249a, 249b, and 249c. The inert gas supplied through the nozzles 249a, 249b and 249c into the process chamber 201 mainly acts as a dilution gas, a purge gas or the carrier gas. For example, a gas such as nitrogen (N₂) gas and a rare gas may be used as the inert gas. For example, the hydrogen (H₂) gas may be used as the carrier gas.

A first gas supplier (which is a first gas supply structure or a first gas supply system) is constituted mainly by the gas supply pipe 232a, the MFC 241a and the valve 243a. The first gas supplier may also be referred to as a source supplier (which is a source supply structure or a source supply system). A second gas supplier (which is a second gas supply structure or a second gas supply system) is constituted mainly by the gas supply pipe 232g, the MFC 241g and the valve 243g. The second gas supplier may also be referred to as a reactant supplier (which is a reactant supply structure or a reactant supply system). An inert gas supplier (which is an inert gas supply structure or an inert gas supply system) is constituted mainly by the gas supply pipes 232g, 232h and 232d, the MFCs 241g, 241h and 241d, and the valves 243g, 243h and 243d. The gas supply pipes 232b and 232c, the MFCs 241b and 241c and the valves 243b and 243c may not be used or may be used as a supplier (which is a supply structure or a supply system) of supplying a dopant or a cleaning gas.

The source supplier is configured such that the source whose flow rate is adjusted can be supplied toward the plurality of zones (that is, the entirety of the first zone, the second zone and the third zone) through the nozzle 249a. An oxidizing agent supplier (which is an oxidizing agent supply structure or an oxidizing agent supply system) serving as a part of the reactant supplier is configured such that the oxidizing agent whose flow rate is adjusted can be supplied toward the plurality of zones (that is, the entirety of the first zone, the second zone and the third zone) through the nozzle 249b. A nitriding agent supplier (which is a nitriding agent supply structure or a nitriding agent supply system) serving as a part of the reactant supplier is configured such that the nitriding agent whose flow rate is adjusted can be supplied toward the plurality of zones (that is, the entirety of the first zone, the second zone and the third zone) through the nozzle 249c. The inert gas supplier is configured such that the inert gas whose flow rate is adjusted respectively for the nozzles 249a, 249b and 249c can be supplied toward the plurality of zones (that is, the entirety of the first zone, the second zone and the third zone) through each of the nozzles 249a, 249b and 249c.

An exhaust hole (exhaust slit) 204c is provided on a side surface (side wall) of the inner tube 204. For example, the exhaust hole 204c may be of a narrow slit-shaped through-hole elongating vertically. For example, the exhaust hole 204c is of a rectangular shape when viewed from front, and is provided from a lower portion to an upper portion of the side wall of the inner tube 204. An inner space of the process chamber 201 and an exhaust space 205 which is an annular space (gap) between the inner tube 204 and the outer tube 203 are in communication with each other through the exhaust hole 204c. The exhaust hole 204c is arranged on a straight line connecting a center of the buffer structure 204a in a left-right direction in FIG. 2 and a center of the inner tube 204 when viewed from above. That is, the buffer structure 204a and the exhaust hole 204c face each other with a center C2 of the wafer 200 accommodated in the process chamber 201 interposed therebetween. In addition, the discharge hole 250a of the nozzle 249a and the exhaust hole 204c are located on a straight line passing through the center C2. The exhaust hole 204c is configured such that the gas is exhausted along a direction perpendicular to the wafer arrangement direction.

As shown in FIG. 1, an exhaust pipe 231 through which an inner atmosphere of the process chamber 201 is exhausted via the exhaust space 205 is connected to a lower portion of the outer tube 203. A vacuum pump 246 serving as a vacuum exhaust apparatus is connected to the exhaust pipe 231 through a pressure sensor 245 serving as a pressure detector (pressure detecting structure) configured to detect an inner pressure of the exhaust space 205 (that is, an inner pressure of the process chamber 201) and an APC (Automatic Pressure Controller) valve 244 serving as a pressure regulator (which is a pressure adjusting structure). With the vacuum pump 246 in operation, the APC valve 244 may be opened or closed to perform a vacuum exhaust of the inner atmosphere of the process chamber 201 or stop the vacuum exhaust. In addition, with the vacuum pump 246 in operation, an opening degree of the APC valve 244 may be adjusted in order to adjust the inner pressure of the process chamber 201 based on pressure information detected by the pressure sensor 245. An exhauster (which is an exhaust system or an exhaust line) is constituted mainly by the exhaust pipe 231, the APC valve 244 and the pressure sensor 245. The exhauster may further include the exhaust hole 204c, the exhaust space 205 and the vacuum pump 246.

The lower end opening of the manifold 209 is airtightly (hermetically) sealed by the seal cap 219 through the O-ring 220b. A rotator 267 configured to rotate the boat 217 is provided below the seal cap 219. A rotating shaft 255 of the rotator 267 is connected to the boat 217 through the seal cap 219. As the rotator 267 rotates the boat 217, the wafers 200 accommodated in the boat 217 are rotated. The seal cap 219 may be elevated or lowered in the vertical direction by the boat elevator 115 serving as an elevator vertically provided outside the reaction tube 210. The boat elevator 115 serves as a transfer device (which is a transfer structure) that transfers (loads) the boat 217 and the wafers 200 supported by the boat 217 into the process chamber 201 or transfers (unloads) the boat 217 and the wafers 200 supported by the boat 217 out of the process chamber 201 by elevating or lowering the seal cap 219.

The boat 217 serving as a substrate retainer is configured such that the wafers 200 (for example, 25 wafers to 200 wafers) are accommodated (or supported) in the vertical direction in the boat 217 while the wafers 200 are horizontally oriented with their centers C2 aligned with one another with a predetermined interval therebetween in a multistage manner. For example, the boat 217 is made of a heat resistant material such as quartz and SiC. For example, a plurality of heat insulation plates 218 made of a heat resistant material such as quartz and SiC are provided at a lower portion of the boat 217 in a multistage manner.

A temperature sensor 263 serving as a temperature detector is installed between the inner tube 204 and the outer tube 203. The state of the electric conduction to the heater 207 is adjusted based on temperature information detected by the temperature sensor 263 such that a desired temperature distribution of an inner temperature of the process chamber 201 can be obtained. The temperature sensor 263 is provided along an inner lateral surface of the outer tube 203.

### <Inner Tube>

Hereinafter, the inner tube 204, the nozzles 249a, 249b and 249c and the discharge holes 250a, 250b and 250c according to the present embodiments will be described more specifically. An inner diameter of the inner tube 204 according to the present embodiments is smaller than twice a distance between a center C1 of each of the nozzles 249a, 249b and 249c and the center C2 of the wafer 200. Let us assume that an imaginary arc whose diameter is same as the inner diameter of the inner tube 204 surrounding the wafer 200 is located at an opening portion of the buffer structure 204a when viewed from above. Then, the center C1 of each of the nozzles 249a, 249b and 249c is located outside the imaginary arc, and each of the discharge holes 250a, 250b and 250c opens toward a radially outward direction from the wafer 200. In other words, the buffer structure 204a protrudes outward from the imaginary arc such that the nozzles 249a, 249b and 249c arranged inside the buffer structure 204a do not interfere with the inner lateral surface of the inner tube 204.

### <Nozzles>

For example, each of the nozzles 249a, 249b and 249c according to the present embodiments is of a cylindrical shape. However, the technique of the present disclosure is not limited thereto. For example, the shape of each of the nozzles 249a, 249b and 249c can be appropriately changed to, for example, an elliptical cylinder shape. The nozzles 249a, 249b and 249c are installed apart from the inner lateral surface of the inner tube 204. The mixed gas is supplied to the nozzles 249a, 249b and 249c through the confluent portions 233a, 233b and 233c.

### <Discharge Hole>

The discharge holes 250a, the discharge holes 250b and the discharge holes 250c according to the present embodiments are provided at the nozzles 249a, 249b and 249c, respectively, along the wafer arrangement direction. For example, each of the discharge holes 250a, 250b and 250c is of a perfect circle shape when viewed from front. However, the technique of the present disclosure is not limited thereto. For example, each of the discharge holes 250a, 250b and 250c may be of another shape such as an elliptical shape. The mixed gas is discharged into the inner tube 204 through the discharge holes 250a, the discharge holes 250b and the discharge holes 250c.

According to the present embodiments, an interval between adjacent discharge holes of the discharge holes 250a (hereinafter, also simply referred to as an "interval of the discharge holes"), an interval of the discharge holes 250b and an interval of the discharge holes 250c are set to be gradually narrowed from upstream ends toward downstream ends of the nozzles 249a, 249b and 249c in the gas flow direction, respectively, such that flow rates of the gas discharged per unit length of the nozzles 249a, 249b and 249c are uniform. That is, the interval of the discharge holes 250a located more upstream in the nozzle 249a is set to be greater than the interval of the discharge holes 250a located more downstream in the nozzle 249a, the interval of the discharge holes 250b located more upstream in the nozzle 249b is set to be greater than the interval of the discharge holes 250b located more downstream in the nozzle 249b, and the interval of the discharge holes 250c located more upstream in the nozzle 249c is set to be greater than the interval of the discharge holes 250c located more downstream in the nozzle 249c. Therefore, the same amount of the mixed gas is supplied to a unit volume of the wafer 200 in at least the first zone and the second zone of the wafer arrangement region in the inner tube 204. That is, according to the present embodiments, instead of setting the interval of the discharge holes 250a, the interval of the discharge holes 250b and the interval of the discharge holes 250c to be equal to the arrangement interval of the wafers 200 (that is, an interval between adjacent wafers among the wafers 200), the interval of the discharge holes 250a, the interval of the discharge holes 250b and the interval of the discharge holes 250c may be set to be different from the arrangement interval of the wafers 200. In the present specification, the term "unit volume of the wafer 200" is defined as a volume of a space with a predetermined height on the surface of the wafer 200 to which a film-forming process is performed. In the third zone, the gas is exhausted more intensely as it approaches the exhaust pipe 231. Therefore, in order to adjust a partial pressure of the mixed gas in the third zone to be equal to that of the mixed gas in the other zones, it may be preferable to increase a supply amount of the mixed gas as a location of each of the discharge holes 250a, 250b and 250c becomes lower.

As shown in FIG. 2, a discharge direction of each of the discharge holes 250a, 250b and 250c is not toward the wafer 200 (which is provided below the imaginary arc described above) accommodated in the boat 217 but toward the inner lateral surface (which is provided above the imaginary arc described above) of the buffer structure 204a of the inner tube 204. In other words, the discharge direction extends radially outward from the center C1 of each of the discharge holes 250a, 250b and 250c. The discharge direction is radially outward from the wafer 200 so as not to overlap the wafer 200 when viewed from above.

Although not shown, the discharge direction of each of the discharge holes 250a, 250b and 250c when viewed from side is a horizontal direction orthogonal to the wafer arrangement direction (vertical direction). However, the technique of the present disclosure is not limited thereto. For example, the discharge direction when viewed from side may be a diagonally upward direction or a diagonally downward direction.

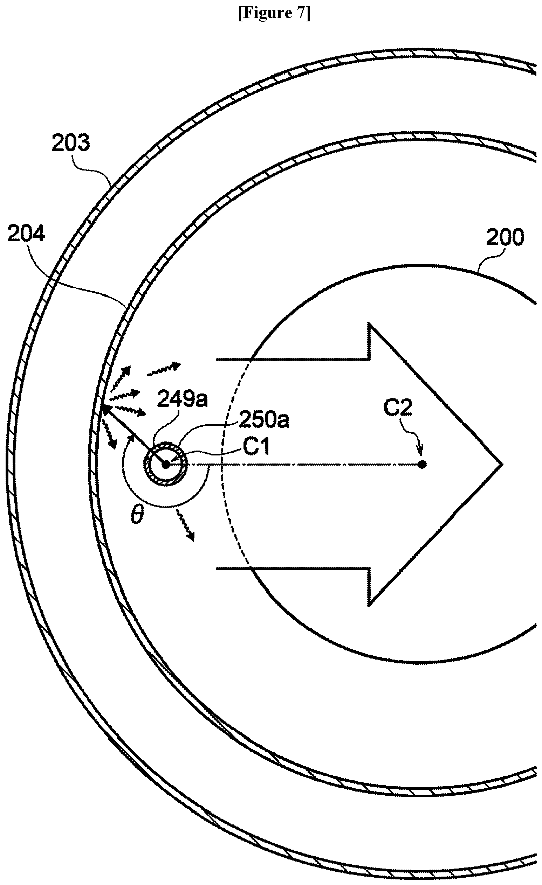

According to the present embodiments, the mixed gas discharged through each of the discharge holes 250a, 250b and 250c reaches the inner lateral surface of the buffer structure 204a of the inner tube 204 before the mixed gas reaches the wafer 200, and collides with the inner lateral surface of the buffer structure 204a (see FIGS. 7 through 9). By making the mixed gas collide with the inner lateral surface of the buffer structure 204a, it is possible to promote dispersing and mixing of the plurality of gases (that is, the mixed gas).

Further, according to the present embodiments, an angle θ between the discharge direction of each of the discharge holes 250a, 250b and 250c and an imaginary line from the center C1 of each of the nozzles 249a, 249b and 249c to the center C2 of the wafer 200, when viewed from above, is set to an angle greater than 90 ° and less than 270 ° (see FIGS. 7 through 9). The angle θ may be measured in either a clockwise direction or a counterclockwise direction.

According to the present embodiments, the center C1 of each of the nozzles 249a, 249b and 249c is located outside the imaginary arc described above of the inner tube 204, and the angle θ is set to be greater than 90 ° and less than 270 °. By setting the angle θ as described above, the mixed gas discharged into the buffer structure 204a through the discharge holes 250a, 250b and 250c is directed not toward the inner lateral surface of the inner tube 204 but toward the inner lateral surface of the buffer structure 204a. That is, the effect of promoting dispersing and mixing of the first gas and the second gas caused by the collision of the mixed gas with the inner lateral surface of the buffer structure 204a can be obtained more reliably. On the other hand, when the angle θ is 90 ° or less or 270 ° or more, the dispersing and mixing effects obtained by the collision of the mixed gas with the inner lateral surface of the buffer structure 204a is lower compared to a case where the angle θ is greater than 90 ° and less than 270 °.

In addition, it is preferable that a gap between the inner lateral surface of the buffer structure 204a of the inner tube 204 and each of the nozzles 249a, 249b and 249c is about 1 mm. When the gap described above is less than about 1 mm, it is difficult to lower an inner pressure of each of the nozzles 249a, 249b and 249c. Further, when the gap described above is equal to or greater than 1 mm, the angle θ which indicates the discharge direction of each of the discharge holes 250a, 250b and 250c can be set appropriately within a range from 90 ° to 270 °. In addition, as long as the angle θ is greater than 90 ° and less than 270 °, for example, the mixed gas may be made to collide with adjacent nozzles to promote dispersing and mixing of the plurality of gases.

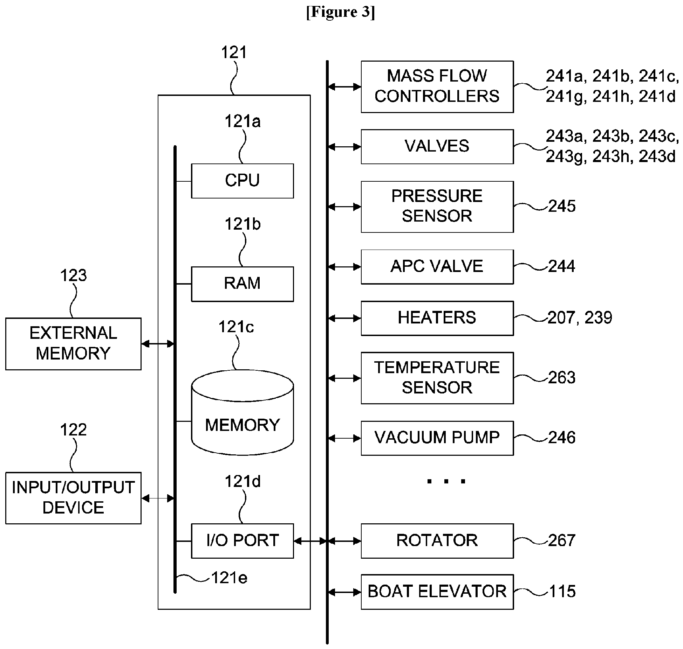

As shown in FIG. 3, a controller 121 serving as a control device (control structure) is constituted by a computer including a CPU (Central Processing Unit) 121a, a RAM (Random Access Memory) 121b, a memory 121c and an I/O port 121d. The RAM 121b, the memory 121c and the I/O port 121d may exchange data with the CPU 121a through an internal bus 121e. For example, an input/output device 122 such as a touch panel is connected to the controller 121.

The memory 121c is configured by a component such as a flash memory and a hard disk drive (HDD). For example, a control program configured to control the operation of the substrate processing apparatus or a process recipe containing information on the sequences and conditions of a substrate processing described later is readably stored in the memory 121c. The process recipe is obtained by combining steps (sequences or processes) of the substrate processing described later such that the controller 121 can execute the steps to acquire a predetermined result, and functions as a program. Hereafter, the process recipe and the control program may be collectively or individually referred to as a "program". In addition, the process recipe may also be simply referred to as a "recipe". In the present specification, the term "program" may refer to the recipe alone, may refer to the control program alone, or may refer to both of the recipe and the control program. The RAM 121b functions as a memory area (work area) where a program or data read by the CPU 121a is temporarily stored.

The I/O port 121d is connected to the above-described components such as the MFCs 241a, 241b, 241c, 241g, 241h and 241d, the valves 243a, 243b, 243c, 243g, 243h and 243d, the pressure sensor 245, the APC valve 244, the vacuum pump 246, the heater 207, the tape heater (not shown), the port heater 239, the temperature sensor 263, the rotator 267 and the boat elevator 115.

The CPU 121a is configured to read the control program from the memory 121c and execute the read control program. In addition, the CPU 121a is configured to read the recipe from the memory 121c in accordance with an operation command inputted from the input/output device 122. According to the contents of the read recipe, the CPU 121a may be configured to be capable of controlling various operations such as flow rate adjusting operations for various gases by the MFCs 241a, 241b, 241c, 241g, 241h and 241d, opening and closing operations of the valves 243a, 243b, 243c, 243g, 243h and 243d, an opening and closing operation of the APC valve 244, a pressure adjusting operation by the APC valve 244 based on the pressure sensor 245, a start and stop of the vacuum pump 246, temperature adjusting operations by the heater 207, the tape heater and the port heater 239 based on the temperature sensor 263, an operation of adjusting the rotation and the rotation speed of the boat 217 by the rotator 267 and an elevating and lowering operation of the boat 217 by the boat elevator 115.

The controller 121 may be embodied by installing the above-described program stored in an external memory 123 into a computer. For example, the external memory 123 may include a magnetic disk such as a hard disk drive (HDD), an optical disk such as a CD, a magneto-optical disk such as an MO and a semiconductor memory such as a USB memory. The memory 121c or the external memory 123 may be embodied by a non-transitory computer readable recording medium. Hereafter, the memory 121c and the external memory 123 may be collectively or individually referred to as a recording medium. In the present specification, the term "recording medium" may refer to the memory 121c alone, may refer to the external memory 123 alone, or may refer to both of the memory 121c and the external memory 123. Instead of the external memory 123, a communication means such as the Internet and a dedicated line may be used for providing the program to the computer.

### <Substrate Processing Method>

Hereinafter, as a part of a manufacturing process of a semiconductor device, an exemplary sequence of a substrate processing (also referred to as the "film-forming process") of forming a film on the wafer 200 will be described. The substrate processing of forming the film is performed using the substrate processing apparatus described above. In the following description, an example of forming the film on the wafer 200 serving as a substrate by alternately supplying a first process gas (source gas) and a second process gas (reactive gas) to the wafer 200 will be described.

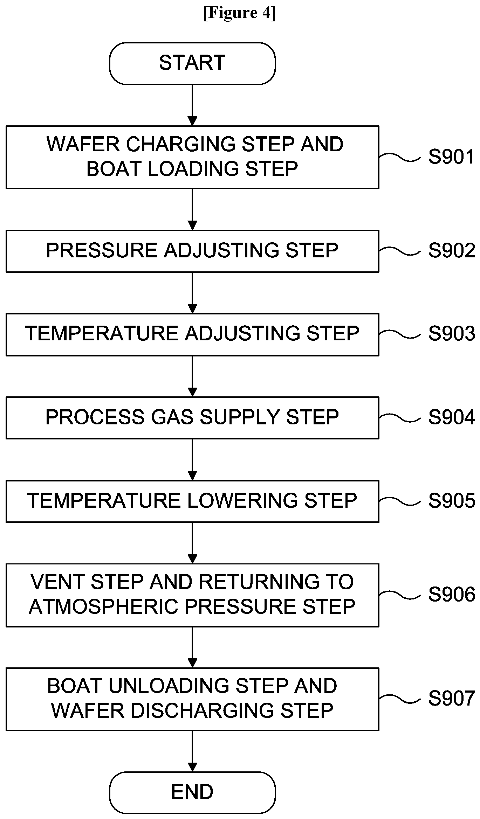

Hereinafter, an example of forming a silicon-rich silicon nitride film (hereinafter, also referred to as an "SiN film") on the wafer 200 will be described with reference to FIG. 4. In the following description, the operations of the components constituting the substrate processing apparatus are controlled by the controller 121.

In the film-forming process according to the present embodiments, the SiN film is formed on the wafer 200 by exposing the mixed gas of the source gas and the reactive gas to the wafer 200 in the process chamber 201 using a CVD (Chemical Vapor Deposition) method.

In the present specification, the term "wafer" may refer to "a wafer itself (that is, a bare wafer)", or may refer to "a wafer and a stacked structure (aggregated structure) of a predetermined layer (or layers) or a film (or films) formed on a surface of a wafer". In the present specification, the term "a surface of a wafer" may refer to "a surface of a wafer itself', or may refer to "a surface of a predetermined layer or a film formed on a wafer", that is, a top surface (uppermost surface) of the wafer as a stacked structure". In the present specification, the terms "substrate" and "wafer" may be used as substantially the same meaning. That is, the term "substrate" may be substituted by "wafer" and vice versa.

### <S901: Wafer Charging Step and Boat Loading Step>

First, after a standby state of the substrate processing apparatus is released, the wafers 200 are transferred (charged) into the boat 217 (wafer charging step), and the boat 217 with the wafers 200 charged therein is transferred (loaded) into the process chamber 201 by the boat elevator 115 (boat loading step). The wafers 200 are arranged in the boat 217 along the vertical direction. When loading the boat 217 into the process chamber 201, the controller 121 sets a predetermined small flow rate (for example, 50 sccm or less) for the MFC 241a, and controls the valve 243a to open. Thereby, a small amount of the N₂ gas (which is a shaft purge gas) may flow out from the rotator 267. When the boat 217 is completely loaded into the process chamber 201, the seal cap 219 airtightly (hermetically) seals the lower end of the manifold 209 via the O-ring 220b. In addition, a supply of the purge gas may be started by allowing the valve 243a or the valve 243g to be open even during the standby state (i.e., constantly open) before the wafer charging step. By supplying the shaft purge gas, it is possible to prevent (or suppress) particles from outside from adhering to a heat insulator (that is, the plurality of heat insulation plates 218) during the wafer charging step. The purge gas makes it possible to suppress a backflow of a gas such as air into the nozzles 249a, 249b and 249c.

### <S902: Pressure Adjusting Step>

The vacuum pump 246 vacuum-exhausts (decompression-exhausts) the inner atmosphere of the process chamber 201 (that is, a space in which the wafers 200 are accommodated) until the inner pressure of the process chamber 201 reaches and is maintained at a predetermined pressure (vacuum degree). In the pressure adjusting step S902, the inner pressure of the process chamber 201 is measured by the pressure sensor 245, and the APC valve 244 is feedback-controlled based on the measured pressure information. The vacuum pump 246 is continuously operated until at least the processing of the wafer 200 is completed. Further, the controller 121 controls the MFC 232g, the valve 243g and the APC valve 244 such that a small amount of the N₂ gas (which is a vent gas) is supplied. The vent gas or the shaft purge gas supplied as described above is then exhausted. It is preferable that the vent gas is continuously supplied at least while the process gas that generates a solid by-product is being supplied into the process chamber 201. Alternatively, the vent gas may be supplied continuously during the film-forming process.

### <S903: Temperature Adjusting Step>

The heater 207 heats the process chamber 201 such that a temperature of the wafer 200 in the process chamber 201 reaches and is maintained at a predetermined temperature. In the temperature adjusting step S903, the state of electric conduction to the heater 207 is feedback-controlled based on the temperature information detected by the temperature sensor 263 such that a flat temperature distribution is obtained in the process chamber 201. The heater 207 continuously heats the process chamber 201 until at least the processing of the wafer 200 is completed.

### <S904: Process Gas Supply Step>

When the inner temperature of the process chamber 201 is stabilized at a pre-set process temperature (first temperature), a source gas and reactive gas supply step and a process gas exhaust step described below are performed as the process gas supply step. During the process gas supply step, the rotator 267 rotates the boat 217 via the rotating shaft 255 such that the wafers 200 are rotated.

### <Source Gas and Reactive Gas Supply Step>

The valve 243a is opened to supply the source gas serving as the first gas (first process gas) according to the present embodiments into the gas supply pipe 232a. For example, the HCDS gas is supplied to be used as the source gas. A flow rate of the source gas is adjusted by the MFC 241a.

In addition, the valve 243g is opened to supply the reactive gas serving as the second gas (second process gas) according to the present embodiments into the gas supply pipe 232g. For example, the NH₃ gas serving as the nitrogen-containing gas is supplied to be used as the reactive gas. A flow rate of the reactive gas is adjusted by the MFC 241g. By merging and mixing the source gas and the reactive gas at the confluent portion 233a, the mixed gas containing the source gas and the reactive gas is generated. Hereinafter, the mixed gas of the source gas and the reactive gas may also be simply referred to as the "source gas". The mixed gas is uniformly well mixed and a temperature of the mixed gas is elevated while the mixed gas flows through the third supply pipe heated by the tape heater.

The source gas serving as the mixed gas flows through the nozzle 249a and then is supplied to the inner tube 204 through the discharge holes 250a. By further heating the source gas in the nozzle 249a, the source gas may react with a part of the reactive gas to generate a substance such as a molecule whose composition is the same as that of the film (that is, the SiN film) formed on the wafer 200, a film precursor whose composition is different from that of the film formed on the wafer 200 and a polymer thereof. The reaction products described above may be supplied into the inner tube 204 by being carried by a flow of an unreacted gas (that is, the source gas which did not react with the reactive gas). It is preferable that the reaction in the nozzle 249a is suppressed so as to remain incomplete. In the source gas and the reactive gas supply step, the source gas is discharged through the discharge holes 250a not toward the boat 217 but toward the inner lateral surface of the buffer structure 204a of the inner tube 204, and then collides with the inner lateral surface of the buffer structure 204a. By making the source gas collide with the inner lateral surface of the buffer structure 204a, it is possible to promote dispersing and mixing of the source gas in the entire vertical and horizontal directions in the buffer structure 204a. Thereafter, the source gas forms a cross flow across the wafer 200, flows toward the boat 217 in the process chamber 201, and is supplied to the wafer arrangement region. In FIG. 2, the cross flow is illustrated by a downward white arrow in the wafer 200. After contributing to the film-forming process on the wafer 200, the source gas is exhausted through the exhaust pipe 231 via the exhaust hole 204c and the exhaust space 205.

In the source gas and the reactive gas supply step, the controller 121 performs a constant pressure control based on the first pressure as a target pressure. However, in an initial stage of supplying the source gas, the inner pressure of the process chamber 201 is considerably lower than the target pressure. Thus, the APC valve 244 may be fully closed. However, when a sub exhaust valve (not shown) (which is not related to the constant pressure control) remains open, most of the vent gas and the shaft purge gas are discharged to the vacuum pump 246 through the sub exhaust valve. Alternatively, the APC valve 244 may be operated so as not to be fully closed but to allow a minute flow rate of the gas constantly flowing through the APC valve 244.

### <Process Gas Exhaust Step>

After the film of a desired thickness is formed, the valves 243a and 243g are closed to stop the supply of the source gas and the reactive gas into the process chamber 201, and a pressure control is performed with the APC valve 244 fully opened. As a result, the inner atmosphere of the process chamber 201 is vacuum-exhausted from the process chamber 201 to remove by-products or a residual gas in the process chamber 201 which did not react or which contributed to the formation of the film. In the process gas exhaust step, the valve 243b or 243c may be opened, and the residual gas may be purged by the inert gas supplied into the process chamber 201. A flow rate of the inert gas may be adjusted by the MFC 241h or 241d. The flow rate of the purge gas at the nozzle 249b or 249c is set such that a partial pressure of a low vapor pressure gas is lower than a saturated vapor pressure in an exhaust path, or such that a flow velocity of the gas in the inner tube 204 is sufficient to overcome a diffusion velocity. Usually, the flow rate of the purge gas through the nozzle 249b or 249c is much greater than that of the purge gas at the nozzle 249a or the rotating shaft 255.

### <S905: Temperature Lowering Step>

In the temperature lowering step S905, the inner temperature of the process chamber 201 is gradually lowered, when necessary, by stopping the temperature adjusting step S903 which has been continued during the film-forming process or by re-setting the predetermined temperature of the temperature adjusting step S903 to a lower temperature. In addition, before the temperature lowering step S905, an annealing process may be performed by maintaining the inner temperature of the process chamber 201 at a second temperature higher than the process temperature (first temperature) of the process gas supply step S904 for a predetermined time.

### <S906: Vent Step>

The inert gas is introduced through a component such as the nozzle 249b and a break filter (not shown) installed at the substrate processing apparatus until the inner pressure of the process chamber 201 reaches and is maintained at the atmospheric pressure. When the inert gas is introduced through the nozzle 249b, the controller 121 sets a predetermined large flow rate (for example, 2 slm or more) for the MFC 241h and controls the valve 243h to open. When the inner pressure of the process chamber 201 reaches and is maintained at the atmospheric pressure, the controller 121 sets a predetermined small flow rate (for example, 50 sccm or less) for the MFC 241h or controls the valve 243h to be closed. The steps S905 and S906 may be performed in parallel, or the step S906 may be performed before the step S905.

### <S907: Boat Unloading Step and Wafer Discharging Step>

The seal cap 219 is slowly lowered by the boat elevator 115 and the lower end of the manifold 209 is opened. Then, the boat 217 with the processed wafers 200 charged therein is unloaded (transferred) out of the inner tube 204 through the lower end of the manifold 209 (boat unloading step). After the boat 217 is unloaded, the processed wafers 200 are discharged (transferred) from the boat 217 by a transfer device (not shown) (wafer discharging step).

The steps described above constitutes a method of manufacturing a semiconductor device using the substrate processing apparatus according to the present embodiments. While the present embodiments are described by way of an example in which the SiN film is formed using the nitrogen-containing gas as the reactive gas, the technique of the present disclosure is not limited thereto. For example, the film-forming process may be performed using the oxygen-containing gas as the reactive gas.

### <Relationship between Inner Pressure of Nozzle and Diameter of Discharge Hole>

In the source gas and reactive gas supply step of the method of manufacturing the semiconductor device according to the present embodiments, the discharge direction of each of the discharge holes 250a, 250b and 250c is toward the inner lateral surface of the buffer structure 204a. Thereby, the mixed gas discharged through each of the discharge holes 250a, 250b and 250c collides with the inner lateral surface of the buffer structure 204a of the inner tube 204, and then is supplied to each of the wafers 200. As a result, it is possible to provide the mixed gas with a uniform mixing ratio to each of the wafers 200 in the inner tube 204 without using a special gas mixer. That is, according to the present embodiments, in addition to increasing a diameter of each of the discharge holes 250a, 250b and 250c, it is possible to lower the inner pressure of each of the nozzles 249a, 249b and 249c by adjusting the discharge direction of each of the discharge holes 250a, 250b and 250c.

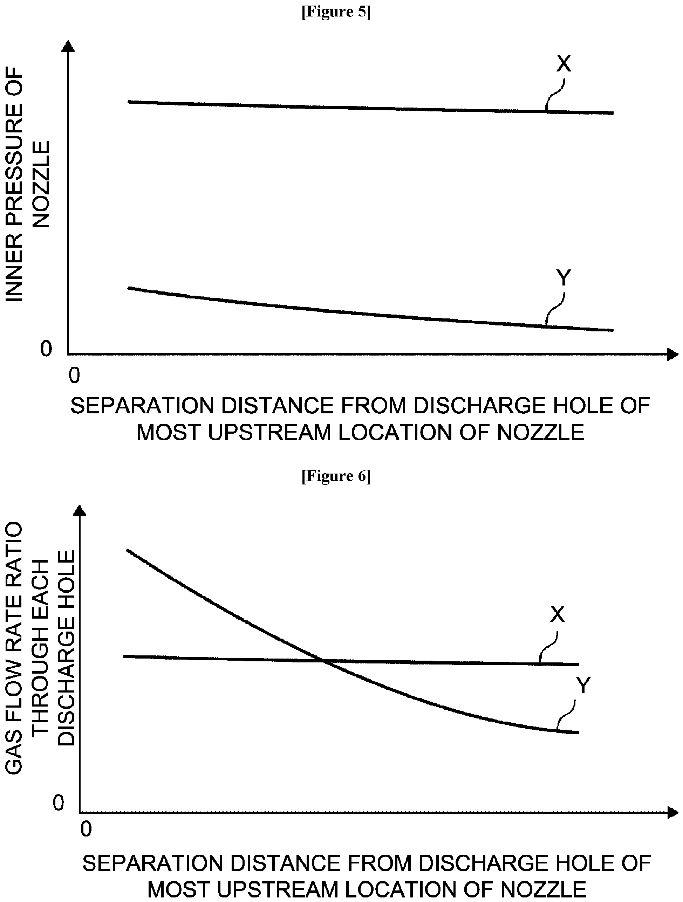

Hereinafter, a relationship between the inner pressure of the nozzle such as the nozzles 249a, 249b and 249c and the diameter of each discharge hole such as the discharge holes 250a, the discharge holes 250b and the discharge holes 250c will be described with reference to FIGS. 5 and 6. For example, in case a plurality of circular discharge holes are aligned side by side at the single nozzle when viewed from front, the inner pressure of the nozzle may decrease from the upstream end to the downstream end of the nozzle as shown in FIG. 5. In an upper portion of FIG. 5, a curve "X" indicates an inner pressure of the reference nozzle obtained at respective positions of its discharge holes located from an upstream end to a downstream end of the reference nozzle, wherein the discharge holes are arranged at the reference nozzle along the vertical direction. The gas in the reference nozzle flows from a lower side to an upper side of the reference nozzle. In addition, the discharge holes of the reference nozzle are arranged at a regular interval, and diameters of the discharge holes of the reference nozzle are the same.

In a lower portion of FIG. 5, a curve "Y" indicates an inner pressure of a comparative nozzle obtained at respective positions of its discharge holes located from an upstream end to a downstream end of the comparative nozzle, wherein the discharge holes are arranged at the comparative nozzle along the vertical direction. An interval of the discharge holes and a shape of each discharge hole of the comparative nozzle are the same as those of the reference nozzle. However, a diameter of each discharge hole of the comparative nozzle is 2.5 times as great as that of the reference nozzle. As shown in FIG. 5, at the entire positions of the discharge holes located from the upstream end to the downstream end, the inner pressure of the comparative nozzle is lower than that of the reference nozzle, and a spatial variation in the inner pressure of the comparative nozzle is greater than that of the reference nozzle.

Further, in FIG. 6 showing a gas flow rate ratio of each of the plurality of discharge holes, a curve "X" indicates a gas flow rate ratio of the reference nozzle and a curve "Y" indicates a gas flow rate ratio of the comparative nozzle. In addition, each gas flow rate ratio indicated by the curves X and Y in FIG. 6 is normalized by a total discharge flow rate. If the diameter of each discharge hole is constant, the inner pressure and a discharge flow rate are proportional to each other. In that case, the curves X and Y shown in FIG. 6 would be similar to the curves X and Y shown in FIG. 5, respectively. However, a difference in the gas flow rate ratio between the upstream portion and the downstream portion of the comparative nozzle is greater than a difference in the gas flow rate ratio between the upstream portion and the downstream portion of the reference nozzle. It can be seen from FIGS. 5 and 6 that, when the gas is supplied to the wafer 200 simply by using a nozzle (that is, the comparative nozzle) provided with enlarged discharge holes, the inner pressure of the nozzle can be lowered but a non-uniformity of the supply amount of the gas may increase between a wafer located more upstream in the nozzle and a wafer located more downstream in the nozzle.

As another method of decreasing the non-uniformity of the supply amount of the gas, contrary to that described above, increasing the inner pressure of the nozzle and decreasing an influence of a pressure difference between an inside and an outside of the nozzle caused by a discharge hole located in the downstream portion of the nozzle may be considered. However, in such a method, the gas tends to be subject to thermal decomposition more easily in the nozzle as the inner pressure of the nozzle increases. Further, when the mixed gas in which the plurality of gases are mixed is supplied at once using the same nozzle, an increase in the inner pressure of the nozzle may cause an abnormal reaction between the plurality of gases to occur more easily in the nozzle. As a result, the generation of particles in the inner tube 204 may increase. In addition, a new film precursor, which is undesirable for the film-forming process, may be generated by the abnormal reaction between the plurality of gases. Therefore, a thickness uniformity of the film on the surface of the wafer 200 and a thickness uniformity of the films between the wafers 200 may deteriorate. On the other hand, in the nozzle such as the nozzle 249a according to the present embodiments, it is possible to uniformize the supply amount per unit volume by setting the interval of the discharge holes such as the discharge holes 250a to be proportional to the inner pressure of the nozzle or the gas flow rate ratio for each discharge amount.

### <Effects according to Present Embodiments>

According to the present embodiments, the discharge direction of each of the discharge holes 250a, 250b and 250c is not toward the boat 217 supporting the wafer 200 but toward the inner lateral surface of the buffer structure 204a of the inner tube 204. Therefore, the mixed gas discharged through each of the discharge holes 250a, 250b and 250c collides with the inner lateral surface of the buffer structure 204a of the inner tube 204 before the mixed gas reaches the wafer 200. By making the mixed gas collide with the inner lateral surface of the buffer structure 204a, it is possible to promote dispersing and mixing of the plurality of gases in the mixed gas.

Therefore, the uniformly mixed gas can be uniformly supplied to each wafer 200 without increasing the inner pressure of each of the nozzles 249a, 249b and 249c. Therefore, it is possible to prevent the particles generated by increasing the inner pressure of each of the nozzles 249a, 249b and 249c. In addition, the mixed gas colliding with the inner lateral surface of the buffer structure 204a is dispersed and flows toward the boat 217 to form the cross flow along the surface of the wafer 200. As a result, it is possible to efficiently supply the mixed gas to the center of the wafer 200.

That is, even if a mixing degree of the plurality of gases suitable for the substrate processing is not achieved at the time when the mixed gas is discharged into the inner tube 204, it is possible to increase the mixing degree of the plurality of gases by making the plurality of gases collide with the inner lateral surface of the buffer structure 204a. Therefore, as compared with a case in which the mixed gas is supplied to the wafers 200 without colliding with the inner lateral surface of the buffer structure 204a of the inner tube 204, it is possible to achieve the mixing degree of the plurality of gases suitable for the substrate processing before the mixed gas reaches the wafer 200 while suppressing the reaction in the nozzles 249a, 249b and 249c.

Further, according to the present embodiments, the nozzles 249a, 249b and 249c are provided apart from the inner lateral surface of the buffer structure 204a of the inner tube 204. Therefore, each of the discharge holes 250a, 250b and 250c also does not come into contact with the inner lateral surface of the buffer structure 204a. As a result, it is possible to prevent the inner pressure of each of the nozzles 249a, 249b and 249c from increasing due to the narrowing of a flow path of the mixed gas.

Therefore, according to the substrate processing apparatus in the present embodiments, when the mixed gas in which the plurality of gases are mixed is supplied to the wafers 200 in the inner tube 204 as the process gas by using the same nozzle such as the nozzles 249a, 249b and 249c, it is possible to prevent the particles from being generated while lowering the inner pressure of each of the nozzles 249a, 249b and 249c, and it is also possible to improve the thickness uniformity of the film on the surface of the wafer 200 and the thickness uniformity of the films between the wafers 200. In addition, according to the method of manufacturing the semiconductor device using the substrate processing apparatus in the present embodiments, since the adhesion of the particles can be prevented, it is possible to manufacture the semiconductor device in a state where the thickness uniformity of the film on the surface of the wafer 200 and the thickness uniformity of the films between the wafers 200 are improved.

Further, according to the present embodiments, since the discharge direction of each of the discharge holes 250a, 250b and 250c is a horizontal direction substantially orthogonal to the wafer arrangement direction, the mixed gas tends to collide vertically with the inner lateral surface of the buffer structure 204a of the inner tube 204 extending vertically along the vertical direction. As a result, the mixed gas after the collision tends to be turbulent in the inner tube 204 so that it is possible to further promote dispersing and mixing of the mixed gas.

Further, according to the present embodiments, the interval of each of the discharge holes 250a, the discharge holes 250b and the discharge holes 250c is set to be gradually narrowed from the upstream end toward the downstream end of each of the nozzles 249a, 249b and 249c in the gas flow direction, respectively, such that the flow rates of the gas discharged per unit length of the nozzles 249a, 249b and 249c are uniform. Therefore, it is possible to easily uniformize the amount of the mixed gas supplied per unit volume of the wafers 200.

The present embodiments are described by way of an example in which, as a configuration of adjusting the interval between adjacent discharge holes, the interval of the discharge holes in the nozzle is set to be gradually narrowed from the upstream end toward the downstream end of each of the nozzle in the gas flow direction. However, the technique of the present disclosure is not limited thereto, and other configurations may be adopted. For example, a plurality of groups each constituted by an appropriate number of discharge holes may be provided in the nozzle, and adjacent discharge holes in some of the groups are arranged at a regular interval whereas an interval between adjacent groups among the plurality of groups is set to be gradually narrowed from the upstream end toward the downstream end of each of the nozzle in the gas flow direction.

Further, for example, the arrangement interval of the wafers 200 may be set to be constant, and a maximum interval of the discharge holes may be set to be greater than the constant arrangement interval of the wafers 200. That is, an arrangement pattern of the wafers 200 and an arrangement pattern of the discharge holes are not limited to the configuration in which a single discharge hole is associated with a single wafer. In other words, according to the technique of the present disclosure, any pattern may be adopted to adjust the interval of the discharge holes as long as the amount of the mixed gas supplied per unit volume of the wafers 200 can be uniformized.

According to the technique of the present disclosure, in order to supply the same amount of the mixed gas per unit volume of each of the wafers 200 in the wafer arrangement region in the inner tube 204, a method of setting the diameter of each discharge hole in the nozzle to be gradually decreased from the upstream end toward the downstream end of the nozzle in the gas flow direction may be adopted alone or in combination with the method described above. That is, according to the technique of the present disclosure, the diameter of each discharge hole in the nozzle or the interval of the discharge holes or both may be adjusted.

However, a processing accuracy of the nozzle in case of adjusting the interval of the discharge holes is often higher than a processing accuracy of the nozzle in case of adjusting the diameter of each discharge hole. Therefore, as compared with a case in which the method of adjusting the diameter of each discharge hole in the nozzle is used alone, it is easier to uniformize the amount of the mixed gas supplied per unit volume of each of the wafers 200 when the method of adjusting the interval of the discharge holes is used alone.

Further, according to the present embodiments, since the plurality of gases (that is, the mixed gas) collide with each other in the buffer structure 204a, gas flows of opposite directions are likely to occur. Therefore, the mixed gas is further dispersed and mixed in the buffer structure 204a, and flows to the boat 217 as a wide flow (cross flow). As a result, it is possible to form the film of a uniform thickness and a uniform quality on the wafer 200.

Further, according to the present embodiments, the gas supplier including the confluent portions 233a, 233b and 233c where the first supply pipe and the second supply pipe join and the third supply pipe configured to fluidically communicate with the confluent portions 233a, 233b and 233c and the nozzles 249a, 249b and 249c is provided. Therefore, it is possible to stably generate the mixed gas in which the first gas and the second gas are mixed.

Further, according to the present embodiments, it is possible to more efficiently heat the mixed gas flowing in the third supply pipe by the port heater 239 configured to heat the port 237 provided at an end of the third supply pipe before the mixed gas is supplied to the wafers 200. Further, according to the technique of the present disclosure, a heating structure of heating the mixed gas according to the present embodiments is not limited to the port heater 239 and the tape heater. For example, a heater configured to heat at least a part of the third supply pipe through which the mixed gas flows to a predetermined temperature or higher suitable for the substrate processing may be provided, and an arrangement position and a shape thereof may be appropriately changed.

Further, according to the present embodiments, the flow path area of the third supply pipe is equal to or greater than the total flow path area of the first supply pipe and the second supply pipe. Therefore, the inner pressure of the third supply pipe in the upstream portion of each of the nozzles 249a, 249b and 249c does not become higher than those of the first supply pipe and the second supply pipe. As a result, it is possible to prevent the inner pressure of each of the nozzles 249a, 249b and 249c from increasing after the mixed gas is supplied to the nozzles 249a, 249b and 249c through the third supply pipe.

Further, according to the present embodiments, the ceiling structure provided with the end face configured to close the upper end of the inner tube 204 is provided on the upper portion of the inner tube 204. Therefore, it is possible to improve the airtightness inside the inner tube 204, and also possible to improve a supply efficiency of the mixed gas.

Further, according to the present embodiments, the angle θ between the discharge direction of each of the discharge holes 250a, 250b and 250c and the imaginary line from the center C1 of each of the nozzles 249a, 249b and 249c to the center C2 of the wafer 200 may be greater than 90 ° and less than 270 °. Therefore, the effect of promoting the dispersing and mixing of the plurality of gases obtained by the collision of the mixed gas with the inner lateral surface can be improved more reliably.

### <Modified Examples>

Subsequently, other configuration examples of the inner tube and the nozzle of the substrate processing apparatus according to the technique of the present disclosure will be described with reference to a first modified example through a fourth modified example described below.

### <First Modified Example>

As shown in FIG. 7, the technique of the present disclosure may also be applied even when the buffer structure 204a described above is not provided at the inner lateral surface of the inner tube 204. In addition, the technique of the present disclosure may also be applied even when the nozzle 249a alone is provided. Similar to the embodiment described above, according to the first modified example, the discharge direction of the discharge hole 250a of the nozzle 249 is not toward the boat 217 supporting the wafer 200 but toward the inner lateral surface of the inner tube 204. Therefore, the mixed gas discharged through the discharge hole 250a collides with the inner lateral surface of the inner tube 204 before the mixed gas reaches the wafer 200. By making the mixed gas collide with the inner lateral surface of the inner tube 204, it is possible to promote dispersing and mixing of the plurality of gases in the mixed gas.

### <Second Modified Example>

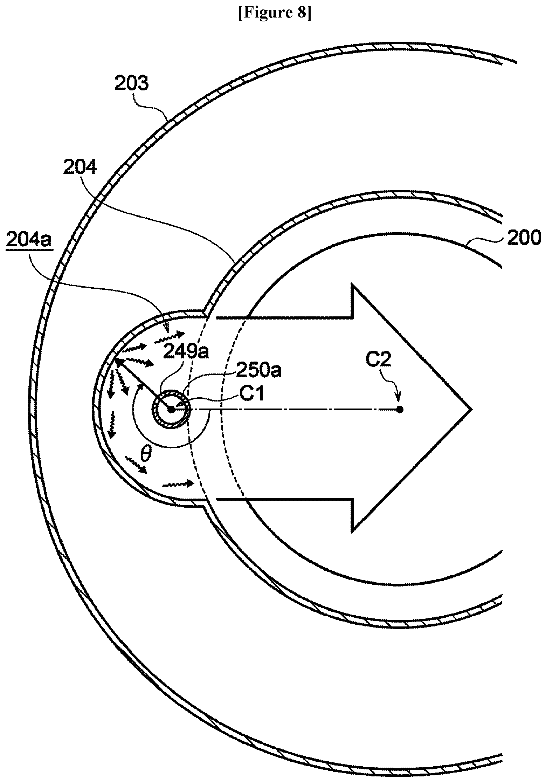

While the embodiments are described by way an example in which the buffer structure 204a bulges in a rectangular shape as shown in FIG. 2 when viewed from above, the technique of the present disclosure is not limited thereto. The shape of the buffer structure 204a may be appropriately changed. For example, as shown in FIG. 8, the buffer structure 204a may bulge in a semicircular shape when viewed from above. According to the technique of the present disclosure, the buffer structure 204a may bulge in a shape where two or more arcs are combined or a straight line and an arc are combined when viewed from above.

### <Third Modified Example>

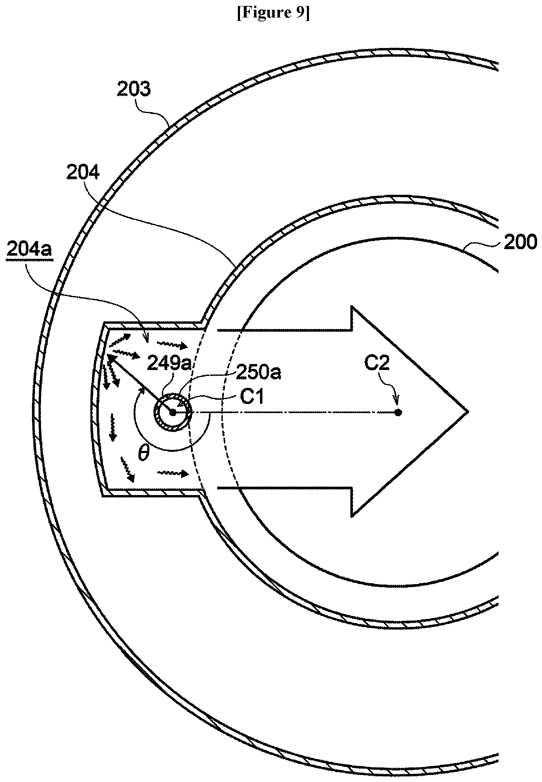

Further, similar to the buffer structure 204a exemplified in FIG. 2, the buffer structure 204a of the third modified example shown in FIG. 9 bulges in a rectangular shape when viewed from above. However, unlike the nozzles 249a, 249b and 249c exemplified in FIG. 2, the nozzle 249a alone is provided in the buffer structure 204a. That is, according to the third modified example, the single nozzle 249a is provided in the buffer structure 204a instead of the three nozzles 249a, 249b and 249c.

### <Fourth Modified Example>

According to the embodiments described above, the wafer arrangement region is divided into three zones along the wafer arrangement direction (vertical direction). In addition, the discharge holes 250a of the nozzle 249a, the discharge holes 250b of the nozzle 249b and the discharge holes 250c of the nozzle 249c are provided at the entire portions of the nozzles 249a, 249b and 249c, respectively, such that the gas can be supplied to the entirety of the three zones.

However, according to the fourth modified example, the wafer arrangement region is divided into three zones along the wafer arrangement direction (vertical direction), and as shown in FIG. 10, nozzles 249a1, 249a2 and 249a3 are provided respectively for the three zones with one-to-one correspondence. Alternatively, the wafer arrangement region may be divided into two zones or four or more zones. As shown in FIG. 11, a discharge direction of each of the discharge hole 250a1 of the nozzles 249a1, the discharge hole 250a2 of the nozzles 249a2 and the discharge hole 250a3 of the nozzles 249a3 is not toward the wafer 200 accommodated in the boat 217 but toward the inner lateral surface of the buffer structure 204a of the inner tube 204, and is configured such that the gas discharged through the nozzles 249a1, 249a2 or 249a3 does not collide with other nozzles.

The nozzle 249a3 shown in a right portion of FIG. 10 and located corresponding to (i.e., such that its discharge holes are open toward) a lowermost zone in the wafer arrangement region is configured as a return nozzle. However, according to the technique of the present disclosure, the nozzle located corresponding to (i.e., such that its discharge holes are open toward) the lowermost zone in the wafer arrangement region is not limited to the return nozzle. Further, the nozzle 249a1 in a left portion and the nozzle 249a2 in a center portion in FIG. 10 are located corresponding to (i.e., such that their discharge holes are open toward) zones other than the lowermost zone in the wafer arrangement region.

The discharge holes 250a3 of the return nozzle (nozzle 249a3) shown in the right portion of FIG. 10 are provided in a rod-shaped portion on a right side of the nozzle 249a3 (return nozzle). Further, the discharge holes 250a1 of the nozzle 249a1 shown in the left portion of FIG. 10 are locally provided in a portion of the nozzle 249a1 higher than the nozzle 249a2 shown in the center portion of FIG. 10. Further, the discharge holes 250a2 of the nozzle 249a2 are locally provided in a portion of the nozzle 249a2 higher than the return nozzle (nozzle 249a3). Therefore, each gas discharged through the three nozzles 249a1, 249a2 and 249a3 in FIG. 10 does not collide with other nozzles adjacent thereto.

Further, as shown in FIGS. 10 and 11, the discharge hole 250a1 of the nozzle 249a1 shown in the left portion of FIG. 10 and the discharge hole 250a2 of the nozzle 249a2 shown in the center portion of FIG. 10 are open toward a right side inner lateral surface of the inner tube 204 such that a space above the return nozzle (nozzle 249a3) is interposed therebetween.

According to the fourth modified example, an angle θ between the discharge direction of each of the discharge holes 250a1, 250a2 and 250a3 and an imaginary line from a center C1 of each of the nozzles 249a1, 249a2 and 249a3 to the center C2 of the wafer 200 when viewed from above is greater than 90 ° and less than 270 °. By setting the angle θ to be greater than 90 ° and less than 270 °, the effect of the dispersing and mixing of the mixed gas obtained by the collision of the mixed gas with the inner lateral surface of the buffer structure 204a can be improved. In addition, the angle θ can be appropriately changed within a range from 90 ° to 270 ° as long as the mixed gas discharged through each of the discharge holes 250a1, 250a2 and 250a3 is sufficiently dispersed and mixed.

Further, according to the fourth modified example, the nozzles 249a1, 249a2 and 249a3 are provided for the three zones, respectively. Therefore, it is possible to adjust the flow rate of the gas for each zone.

Further, according to the fourth modified example, since the mixed gas discharged into the buffer structure 204a collides with the inner lateral surface of the buffer structure 204a without colliding with other nozzles, it is possible to lengthen a flow path of the mixed gas from each of the nozzles 249a1, 249a2 and 249a3 to the wafer 200 in the buffer structure 204a. In other words, it is possible to effectively use an installation space of the three nozzles 249a1, 249a2 and 249a3 in the buffer structure 204a. In addition, by dispersing and mixing the mixed gas in the buffer structure 204a, it is possible to uniformly perform a process such as a heat treatment process and a mixing process of the plurality of gases regardless of a slot position of each of the wafers 200.

Further, according to the fourth modified example, since a flow path of the mixed gas before being discharged is lengthened by the return nozzle, it is possible to lengthen the total flow path of the mixed gas from the nozzle 249a3 (that is, the return nozzle) to the wafer 200. Therefore, it is possible to easily increase the mixing degree of the plurality of gases before being discharged. In addition, since the discharge direction of the discharge hole is radially outward from the center of the wafer 200, it is possible to lengthen the total flow path of the mixed gas from the nozzle to the wafer 200 after the mixed gas is discharged. Therefore, it is possible to easily increase the mixing degree of the plurality of gases even after the plurality of gases are discharged.

Further, according to the fourth modified example, since the mixed gas discharged through the nozzles located corresponding to the zones other than the lowermost zone flows above the return nozzle, it is possible to lengthen the flow path of the mixed gas from the nozzles located corresponding to the zones other than the lowermost zone to the wafer 200. Thereby, it is possible to easily increase the mixing degree of the plurality of gases.

Further, in the fourth modified example, a plurality of gas suppliers such as the gas supplier according to the embodiments described above may be provided respectively for the nozzles 249a1, 249a2 and 249a3 provided respectively for the plurality of zones. For example, the nozzles 249a1, 249a2 and 249a3 are provided so as to replace the nozzles 249b, 249a and 249c of the embodiments described above, respectively, the source gas is supplied through the gas supply pipes 232b and 232c in a manner similar to that of the gas supply pipe 232a, and the reactive gas is supplied through the gas supply pipes 232h and 232d in a manner similar to that of the gas supply pipe 232g. That is, the mixed gas is supplied to each zone by individually providing one or more sets of nozzles and the gas supplier for each zone. By adjusting supply flow rates of the gases, it is possible to improve a uniformity of the films between the plurality of zones. In addition, in the fourth modified example, as in the embodiments described above, the length of the third supply pipe may be set to be long enough for the first gas and the second gas to be uniformly mixed when the mixed gas discharged from the nozzle corresponding to the third supply pipe collides with the inner lateral surface and then is supplied to the wafer 200.

### <Other Embodiments>

While the technique of the present disclosure is described in detail by way of the embodiments and the modified examples described above, the technique of the present disclosure is not limited to the descriptions and the drawings thereof. For example, the above-described embodiments are described by way of an example in which the mixed gas is mixed in advance outside the inner tube. However, the technique of the present disclosure is not limited thereto. For example, the mixed gas may be mixed in the inner tube. For example, the above-described embodiments are described by way of an example in which the film-forming process is performed by the CVD method as the substrate processing by using the substrate processing apparatus. However, the technique of the present disclosure is not limited thereto. That is, the mixing structure of mixing the plurality of gases in advance may be omitted.

The invention may be summarized as follows: Described herein is a substrate processing technique of preventing particle generation while lowering an inner pressure of a nozzle and improving a film thickness uniformity. According to one aspect thereof, a substrate processing apparatus includes a boat for supporting substrates; an inner tube surrounding the boat and provided with an exhaust hole through which a gas is exhausted along a direction orthogonal to an arrangement direction of the substrates; a mixing structure for generating a mixed gas for processing the substrates; and a nozzle installed apart from an inner lateral surface of the inner tube and through which the mixed gas supplied from the mixing structure is discharged into the inner tube via discharge holes arranged at the nozzle along the arrangement direction of the substrates. A discharge direction of each of the discharge holes is not toward the boat but toward the inner lateral surface of the inner tube.

The invention may also be summarized as follows:
1. A substrate processing apparatus comprising:
   an inner tube installed so as to surround a boat and provided with an exhaust hole through which a gas is exhausted along a direction orthogonal to an arrangement direction of the plurality of substrates in the boat;
   a mixing structure configured to generate a mixed gas by mixing a plurality of gases for processing the plurality of substrates, wherein the plurality of gases react with each other at an inner temperature of the inner tube; and
   a nozzle installed apart from an inner lateral surface of the inner tube and through which the mixed gas supplied from the mixing structure is discharged into the inner tube via a plurality of discharge holes arranged at the nozzle along the arrangement direction of the plurality of substrates,
   wherein a discharge direction of each of the plurality of discharge holes is not toward the boat but toward the inner lateral surface of the inner tube.
2. The substrate processing apparatus of item 1, wherein an interval of the plurality of discharge holes is different from an arrangement interval of the plurality of substrates, and
   wherein the discharge direction of each of the plurality of discharge holes is substantially orthogonal to the arrangement direction of the plurality of substrates.
3. The substrate processing apparatus of item 1 and/or 2, further comprising
   a buffer structure protruding outward from the inner lateral surface of the inner tube,
   wherein the nozzle is provided in the buffer structure,
   the discharge direction of each of the plurality of discharge holes is toward an inner lateral surface of the buffer structure, and
   the mixed gas is discharged into the buffer structure via the plurality of discharge holes.
4. The substrate processing apparatus of any one or more of items 1 to 3, wherein an interval of the plurality of discharge holes is set to be gradually narrowed from an upstream end toward a downstream end of the nozzle in a gas flow direction.
5. The substrate processing apparatus of any one or more of items 1 to 4, wherein a diameter of each of the plurality of discharge holes or an interval of the plurality of discharge holes is set such that an amount of the mixed gas supplied per unit volume of each of the plurality of substrates is same along the arrangement direction of the plurality of substrates in the inner tube.
6. The substrate processing apparatus of any one or more of items 1 to 5, wherein
   an arrangement interval of the plurality of substrates is set to be constant, and
   a maximum interval of the plurality of discharge holes is set to be greater than the arrangement interval of the plurality of substrates.
7. The substrate processing apparatus of any one or more of items 1 to 6, wherein the diameter of each of the plurality of discharge holes is set to be gradually increased from an upstream end toward a downstream end of the nozzle in a gas flow direction.
8. The substrate processing apparatus of any one or more of items 1 to 7, wherein a plurality of zones are provided by dividing a substrate arrangement region in the inner tube along the arrangement direction of the plurality of substrates, and a plurality of nozzles comprising the nozzle are provided respectively for the plurality of zones.
9. The substrate processing apparatus of item 8, wherein a discharge direction of each of a plurality of discharge holes of each of the plurality of nozzles is not toward the boat but toward the inner lateral surface of the inner tube such that the mixed gas discharged through a nozzle among the plurality of nozzles does not collide with other nozzles among the plurality of nozzles.
10. The substrate processing apparatus of item 8 and/or 9, wherein the plurality of substrates are arranged along a vertical direction,
   a nozzle among the plurality of nozzles located corresponding to a lowermost zone of the plurality of zones in the substrate arrangement region is configured as a return nozzle, and
   a discharge direction of each of the plurality of discharge holes of the return nozzle is radially outward from a center of each of the plurality of substrates.
11. The substrate processing apparatus of any one or more of items 8 to 10, wherein the plurality of substrates are arranged along a vertical direction,
   the plurality of nozzles comprise: a lowermost nozzle located corresponding to a lowermost zone of the plurality of zones in the substrate arrangement region; and one or more nozzles located corresponding to one or more zones other than the lowermost zone of the plurality of zones in the substrate arrangement region, and
   a plurality of discharge holes of the one or more nozzles are open toward the inner lateral surface of the inner tube such that a space above the lowermost nozzle is interposed therebetween.
12. The substrate processing apparatus of any one or more of items 1 to 11, further comprising a gas supplier comprising:
   a first supply pipe connected to a supply source of a first gas among the plurality of gases;
   a second supply pipe connected to a supply source of a second gas among the plurality of gases; and
   a third supply pipe configured to fluidically communicate with the mixing structure and the nozzle,
   wherein the mixing structure comprises a confluent portion at which the first supply pipe joins the second supply pipe.
13. The substrate processing apparatus of item 12, further comprising
   a heater configured to heat at least a part of the third supply pipe to a predetermined temperature or higher.
14. The substrate processing apparatus of item 13, further comprising
   a port provided at an end of the third supply pipe located opposite to the confluent portion and through which the first gas and the second gas merged with each other is introduced into a process furnace,
   wherein the heater comprises a port heater configured to heat the port.
15. The substrate processing apparatus of any one or more of items 12 to 14, wherein a flow path area of the third supply pipe is equal to or greater than a total flow path area of the first supply pipe and the second supply pipe.
16. The substrate processing apparatus of any one or more of items 12 to 15, wherein a plurality of zones are provided by dividing a substrate arrangement region in the inner tube along the arrangement direction of the plurality of substrates,
   a plurality of nozzles comprising the nozzle are provided respectively for the plurality of zones,
   a plurality of gas suppliers comprising the gas supplier are provided respectively for the plurality of zones, and
   a length of the third supply pipe is set to be long enough for the first gas and the second gas to be uniformly mixed when the first gas and the second gas are supplied through nozzles among the plurality of nozzles corresponding to the first gas and the second gas, respectively.
17. The substrate processing apparatus of any one or more of items 1 to 16, wherein the inner tube is provided with an end face configured to close an upper end of the inner tube.
18. The substrate processing apparatus of any one or more of items 1 to 17, wherein, when viewed from above, an angle θ between the discharge direction of each of the plurality of discharge holes and an imaginary line from a center of the nozzle to a center of each of the plurality of substrates is greater than 90 ° and less than 270 °.
19. A method of manufacturing a semiconductor device using the substrate processing apparatus of any one or more of items 1 to 18, comprising:
   (a) arranging a plurality of substrates in a boat along a predetermined arrangement direction;
   (b) generating a mixed gas in a mixing structure; and
   (c) forming a film on the plurality of substrates by supplying the mixed gas to the boat in an inner tube through a plurality of discharge holes such that the mixed gas is discharged through the plurality of discharge holes toward an inner lateral surface of the inner tube instead of the boat to disperse and further mix the mixed gas.
20. A program that causes, by a computer, a substrate processing apparatus to perform:
   (a) arranging a plurality of substrates in a boat along a predetermined arrangement direction;
   (b) generating a mixed gas in a mixing structure; and
   (c) forming a film on the plurality of substrates by supplying the mixed gas to the boat in an inner tube through a plurality of discharge holes such that the mixed gas is discharged through the plurality of discharge holes toward an inner lateral surface of the inner tube instead of the boat to disperse and further mix the mixed gas.

Further, the technique of the present disclosure may also be applied when components of the substrate processing apparatus shown in the drawings are partially combined. That is, the technique of the present disclosure may include various embodiments not described above.

### [Description of Reference Numerals]

| | | | |
|---|---|---|---|
| 200: | wafer (substrate) | 204: | inner tube |
| 204a: | buffer structure | 204c: | exhaust hole |
| 207: | heater | 217: | boat |
| 232a, 232b and 232c: | gas supply pipes (first supply pipe) | | |
| 232g, 232h and 232d: | gas supply pipes (second supply pipe) | | |
| 233a, 233b and 233c: | confluent portions | | |
| 235a, 235b and 235c: | gas supply pipes (third supply pipe) | | |
| 237: | port | 239: | port heater |
| 249a, 249b and 249c: | nozzles | 249a1, 249a2 and 249a3: | nozzles |
| 250a, 250b and 250c: | discharge holes | 250a1, 250a2 and 250a3: | discharge holes |
| θ: | angle | | |

## Claims

1. A substrate processing apparatus comprising:
an inner tube installed so as to surround a boat and provided with an exhaust hole through which a gas is exhausted along a direction orthogonal to an arrangement direction of the plurality of substrates in the boat;
a mixing structure configured to generate a mixed gas by mixing a plurality of gases for processing the plurality of substrates, wherein the plurality of gases react with each other at an inner temperature of the inner tube; and
a nozzle installed apart from an inner lateral surface of the inner tube and through which the mixed gas supplied from the mixing structure is discharged into the inner tube via a plurality of discharge holes arranged at the nozzle along the arrangement direction of the plurality of substrates,
wherein a discharge direction of each of the plurality of discharge holes is not toward the boat but toward the inner lateral surface of the inner tube.

2. The substrate processing apparatus of claim 1, wherein an interval of the plurality of discharge holes is different from an arrangement interval of the plurality of substrates, and
wherein the discharge direction of each of the plurality of discharge holes is substantially orthogonal to the arrangement direction of the plurality of substrates.

3. The substrate processing apparatus of claim 1 and/or 2, further comprising
a buffer structure protruding outward from the inner lateral surface of the inner tube,
wherein the nozzle is provided in the buffer structure,
the discharge direction of each of the plurality of discharge holes is toward an inner lateral surface of the buffer structure, and
the mixed gas is discharged into the buffer structure via the plurality of discharge holes.

4. The substrate processing apparatus of any one or more of claims 1 to 3, wherein an interval of the plurality of discharge holes is set to be gradually narrowed from an upstream end toward a downstream end of the nozzle in a gas flow direction.

5. The substrate processing apparatus of any one or more of claims 1 to 4, wherein
an arrangement interval of the plurality of substrates is set to be constant, and
a maximum interval of the plurality of discharge holes is set to be greater than the arrangement interval of the plurality of substrates.

6. The substrate processing apparatus of any one or more of claims 1 to 5, wherein a plurality of zones are provided by dividing a substrate arrangement region in the inner tube along the arrangement direction of the plurality of substrates, and a plurality of nozzles comprising the nozzle are provided respectively for the plurality of zones.

7. The substrate processing apparatus of claim 6, wherein the plurality of substrates are arranged along a vertical direction,
a nozzle among the plurality of nozzles located corresponding to a lowermost zone of the plurality of zones in the substrate arrangement region is configured as a return nozzle, and
a discharge direction of each of the plurality of discharge holes of the return nozzle is radially outward from a center of each of the plurality of substrates.

8. The substrate processing apparatus of claim 6 and/or 7, wherein the plurality of substrates are arranged along a vertical direction,
the plurality of nozzles comprise: a lowermost nozzle located corresponding to a lowermost zone of the plurality of zones in the substrate arrangement region; and one or more nozzles located corresponding to one or more zones other than the lowermost zone of the plurality of zones in the substrate arrangement region, and
a plurality of discharge holes of the one or more nozzles are open toward the inner lateral surface of the inner tube such that a space above the lowermost nozzle is interposed therebetween.

9. The substrate processing apparatus of any one or more of claims 1 to 8, further comprising
a gas supplier comprising:
a first supply pipe connected to a supply source of a first gas among the plurality of gases;
a second supply pipe connected to a supply source of a second gas among the plurality of gases; and
a third supply pipe configured to fluidically communicate with the mixing structure and the nozzle,
wherein the mixing structure comprises a confluent portion at which the first supply pipe joins the second supply pipe.

10. The substrate processing apparatus of claim 9, further comprising:
a heater configured to heat at least a part of the third supply pipe to a predetermined temperature or higher; and
a port provided at an end of the third supply pipe located opposite to the confluent portion and through which the first gas and the second gas merged with each other is introduced into a process furnace,
wherein the heater comprises a port heater configured to heat the port.

11. The substrate processing apparatus of claim 9 and/or 10, wherein a flow path area of the third supply pipe is equal to or greater than a total flow path area of the first supply pipe and the second supply pipe.

12. The substrate processing apparatus of any one or more of claims 9 to 11, wherein a plurality of zones are provided by dividing a substrate arrangement region in the inner tube along the arrangement direction of the plurality of substrates,
a plurality of nozzles comprising the nozzle are provided respectively for the plurality of zones,
a plurality of gas suppliers comprising the gas supplier are provided respectively for the plurality of zones, and
a length of the third supply pipe is set to be long enough for the first gas and the second gas to be uniformly mixed when the first gas and the second gas are supplied through nozzles among the plurality of nozzles corresponding to the first gas and the second gas, respectively.

13. The substrate processing apparatus of any one or more of claims 1 to 12, wherein, when viewed from above, an angle θ between the discharge direction of each of the plurality of discharge holes and an imaginary line from a center of the nozzle to a center of each of the plurality of substrates is greater than 90 ° and less than 270 °.

14. A method of manufacturing a semiconductor device using the substrate processing apparatus of any one or more of claims 1 to 13, comprising:
(a) arranging a plurality of substrates in a boat along a predetermined arrangement direction;
(b) generating a mixed gas in a mixing structure; and
(c) forming a film on the plurality of substrates by supplying the mixed gas to the boat in an inner tube through a plurality of discharge holes such that the mixed gas is discharged through the plurality of discharge holes toward an inner lateral surface of the inner tube instead of the boat to disperse and further mix the mixed gas.

15. A program that causes, by a computer, a substrate processing apparatus to perform:
(a) arranging a plurality of substrates in a boat along a predetermined arrangement direction;
(b) generating a mixed gas in a mixing structure; and
(c) forming a film on the plurality of substrates by supplying the mixed gas to the boat in an inner tube through a plurality of discharge holes such that the mixed gas is discharged through the plurality of discharge holes toward an inner lateral surface of the inner tube instead of the boat to disperse and further mix the mixed gas.
